# EUROPEAN PATENT APPLICATION

(11) **EP 4 432 806 A1**
(43) Date of publication of application: **18.09.2024**
(21) Application number: 23206589.6
(22) Date of filing: 30.10.2023
(51) Int. Cl.: H10B 43/27

(54) **SEMICONDUCTOR DEVICE AND ELECTRONIC SYSTEM INCLUDING THE SAME**

(30) Priority: 13.03.2023 KR 20230032673
(71) Applicant: Samsung Electronics Co., Ltd., Suwon-si, Gyeonggi-do 16677 (KR)
(72) Inventor: JUNG, Euntaek, Suwon-si (KR); SUNG, Sukkang, Suwon-si (KR)
(74) Representative: Marks & Clerk LLP

(57) **Abstract**

A semiconductor device includes a substrate, stacking structure, first selection gate electrode, memory gate electrodes stacked on the substrate; a first channel structure penetrating the stacking structure and extending along one direction, a first channel layer, a first dielectric layer between the first channel layer and stacking structure, a channel pad on the first channel layer; an insulation pattern above the stacking structure, a penetration portion exposing some of the first channel structure, a second selection gate electrode on the insulation pattern, a second channel structure extending in one direction penetrating the second selection gate electrode, a contact pattern connected to the first channel structure including a first portion within the penetration portion on an upper surface of the channel pad, and a second portion protruding toward the substrate to include a recess in the channel pad and the first dielectric layer inside a bottom surface of the first portion.

## Description

### 1. Field

The present disclosure relates to a semiconductor device and an electronic system including the semiconductor device.

### 2. Description of the Related Art

A semiconductor is a material that belongs to the intermediate region between a conductor and an insulator. The term "semiconductor" typically refers to a material that conducts electricity under predetermined conditions. Various semiconductor devices can be manufactured using a semiconductor material. For example, memory devices and the like can be manufactured. A memory device may be divided into a volatile memory device and a non-volatile memory device. In the case of a non-volatile memory device, the contents are not deleted even though the power is cut off. The non-volatile memory device can be used in various electronic devices such as portable phones, digital cameras, and PCs.

It is desirable to improve the integration of non-volatile memory devices according to the recent trend of increased storage capacity. The integration of memory devices that are disposed in two dimensions on a flat surface can be limited. Accordingly, a vertical non-volatile memory device that is disposed in three dimensions has been proposed.

### SUMMARY

A semiconductor device according to an embodiment includes: a substrate; a stacking structure that includes a first selection gate electrode and a plurality of memory gate electrodes separately stacked on the substrate; a first channel structure that penetrates the stacking structure and that extends along one direction, and that includes a first channel layer, a first dielectric layer disposed between the first channel layer and the stacking structure, and a channel pad disposed on the first channel layer; an insulation pattern that is disposed above the stacking structure and has a penetration portion exposing at least a portion of the first channel structure; a second selection gate electrode that is disposed on the insulation pattern; and a second channel structure that extends in the one direction to penetrate the second selection gate electrode, and includes a contact pattern connected to the first channel structure, wherein the contact pattern includes a first portion including a portion disposed within the penetration portion on an upper surface of the channel pad, and a second portion that protrudes toward the substrate to include a recess in the channel pad and the first dielectric layer inside a bottom surface of the first portion.

The first portion may have an extension extending outward from an edge of the second portion at the top of the second portion.

A thickness of the extension may be greater than a thickness of the insulation pattern.

An upper surface of the first portion may be disposed closer to the second selection gate electrode than an upper surface of the insulation pattern.

A bottom surface of the second portion may be disposed on the same plane with a portion disposed on the first dielectric layer and a portion disposed on the channel pad.

The first channel structure may include a plurality of first channel structures, the penetration portion may include a plurality of penetration portions respectively corresponding to the plurality of first channel structures, and the insulation pattern may have an integral structure in which parts other than the plurality of penetration portions are connected.

The semiconductor device may further include an upper separation region penetrating the insulation pattern.

The semiconductor device may further include a cell region insulation layer that is disposed between the insulation pattern and the stacking structure and covers an upper surface of the stacking structure and a side surface of the first channel structure, wherein, on a plane, one side of the first portion may overlap the cell region insulation layer and the other side of the first portion overlaps the first channel structure.

A portion of the second portion of the channel pad may overlap the cell region insulation layer in the one direction.

A thickness of the one side of the first portion may be greater than a thickness of the other side of the first portion.

A bottom surface of the one portion of the first portion may be disposed closer to the stacking structure than a bottom surface of the other portion of the first portion.

A thickness of the second portion of the contact pattern may be greater than a thickness of the first portion of the contact pattern.

A width of the second channel structure may be less than a width of the first channel structure.

At least a part of the first channel structure may overlap with the second channel structure in one direction.

A thickness of the second selection gate electrode along the one direction may be greater than a thickness of the first selection gate electrode along the one direction, and the second selection gate electrode may contain a material different from the first selection gate electrode.

The contact area between the contact pattern and the first channel pad can be increased in the semiconductor device, and thus the first channel structure and the second channel structure can be stably connected. Accordingly, reliability of the semiconductor device can be improved.

At least some of the above and other features of the invention are set out in the claims.

### BRIEF DESCRIPTION OF THE DRAWINGS

Features will become apparent to those of skill in the art by describing in detail embodiments with reference to the attached drawings in which:
FIG. 1 is a schematic top plan view of a semiconductor device according to an embodiment.
FIG. 2 is an enlarged view of the region A of FIG. 1.
FIG. 3 is a cross-sectional view of FIG. 1, taken along the line I-I'.
FIG. 4 is an enlarged cross-sectional view of the region B in FIG. 3.
FIG. 5 is a schematic top plan view of a channel structure of the semiconductor device according to an embodiment.
FIG. 6 is an enlarged cross-sectional view of the region C in FIG. 4.
FIG. 7 to FIG. 10 are cross-sectional views corresponding to the region B of FIG. 3, which shows the semiconductor device according to an embodiment.
FIG. 11 and FIG. 12 are cross-sectionals view of a semiconductor device according to an embodiment.
FIG. 13 to FIG. 16 are cross-sectional views of a manufacturing method of a semiconductor device according to embodiments.
FIG. 17 to FIG. 27 are partially enlarged views of a manufacturing method of a semiconductor device according to embodiments.
FIG. 28 schematically shows an electronic system including the semiconductor devices according to some embodiments.
FIG. 29 is a schematic perspective view of an electronic system including a semiconductor device according to some embodiments.
FIG. 30 and FIG. 31 are schematic cross-sectional views of semiconductor packages according to some embodiments.

### DETAILED DESCRIPTION

Hereinafter, with reference to accompanying drawings, various embodiments will be described in detail. The present disclosure may be embodied in many different forms and is not limited to the embodiments described herein.

In order to clearly explain the present disclosure, parts irrelevant to the description may be omitted. The same reference numerals may be applied to the same or similar constituent elements throughout the specification.

In addition, the size and thickness of each component shown in the drawing may be arbitrarily shown for convenience of explanation. Therefore, the present disclosure may not necessarily be limited to what is shown in the drawings. In the drawings, the thickness of layers, films, panels, regions, etc., may be exaggerated for clarity. In addition, for convenience of explanation, the thickness of some layers and regions in the drawings may be exaggerated.

It is to be understood that when an element such as a layer, film, region, or substrate is referred to as being "on" another element, it can be directly on the other element or intervening elements may also be present. In contrast, when an element is referred to as being "directly on" another element, there are no intervening elements present. Further, throughout the specification, the word "on" a target element will be understood to mean positioned above or below the target element, and will not necessarily be understood to mean positioned "at an upper side" based on an opposite to gravity direction.

In addition, unless explicitly described to the contrary, the word "comprise", and variations such as "comprises" or "comprising", will be understood to imply the inclusion of stated elements but not the exclusion of any other elements.

Further, throughout the specification, the phrase "on a plane" or "plan view" refers to viewing a target portion from the top, and the phrase "on a cross-section" refers to viewing a cross-section formed by vertically cutting a target portion from the side.

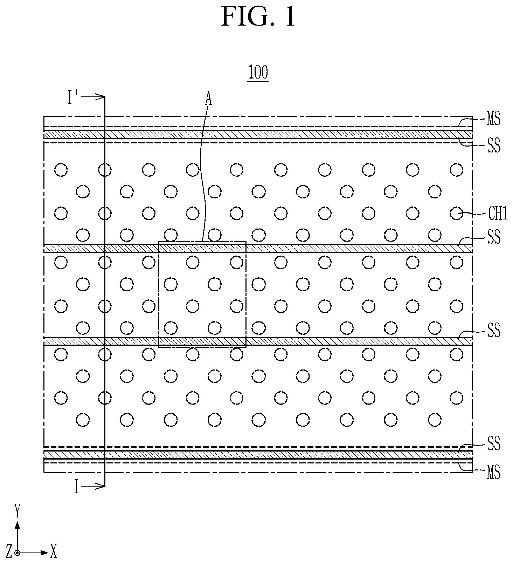

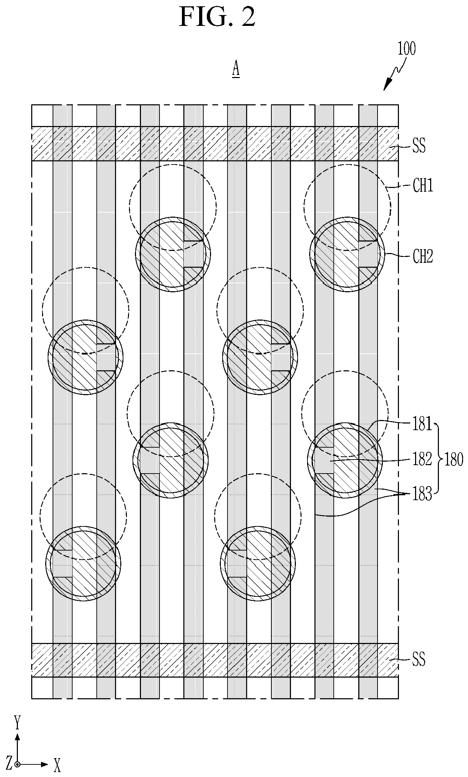

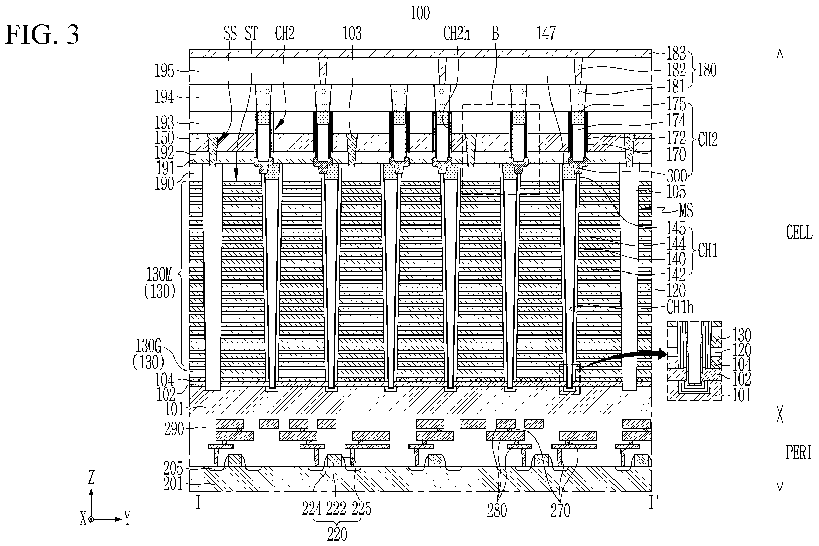

FIG. 1 is a schematic top plan view of a semiconductor device according to an embodiment. FIG. 2 is an enlarged view of the region A of FIG. 1. FIG. 3 is a cross-sectional view of FIG. 1, taken along the line I-I'. For simple illustration, in FIG. 1, a second channel structure CH2 is omitted, and a first channel structure CH1 is mainly illustrated.

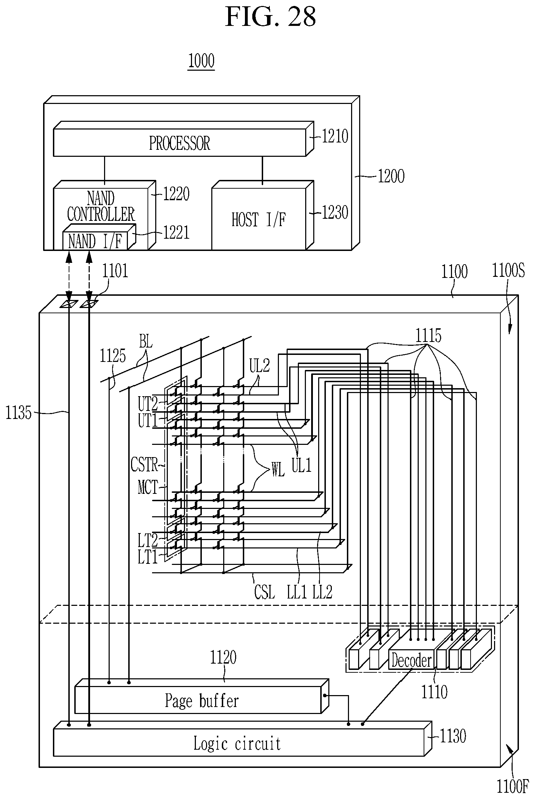

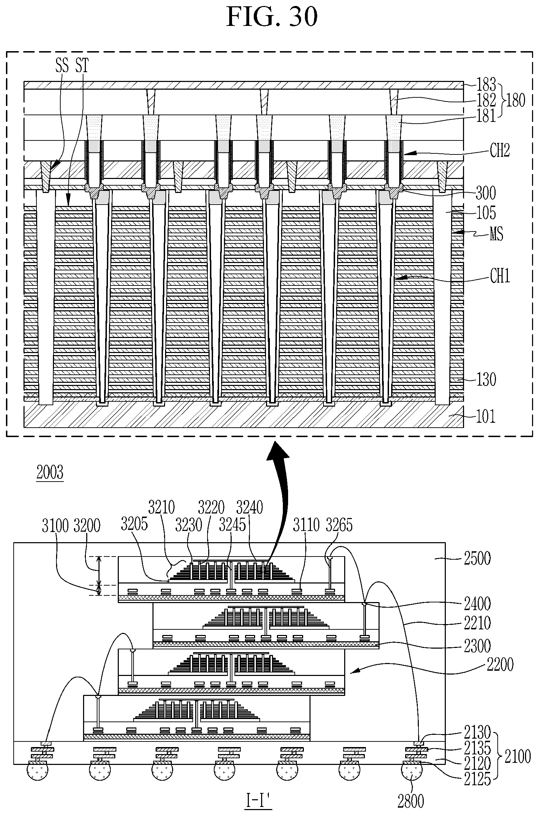

Referring to FIG. 1 to FIG. 3, a semiconductor device 100 according to an embodiment may include a memory cell region CELL and a peripheral circuit region PERI that are vertically stacked. For example, the peripheral circuit region PERI and cell region CELL may respectively be portions corresponding to a first structure 1100F and a second structure 1100S of the semiconductor device 1100 included in the electronic system 1000 as shown in FIG. 28. In some implementations, the peripheral circuit region PERI and the cell region CELL may respectively be portions including a first structure 3100 and a second structure 3200 of the semiconductor chip 2200 as shown in FIG. 30.

The memory cell region CELL may be disposed on top of the peripheral circuit region PERI. In some embodiments, the semiconductor device 100 may have a memory cell region CELL and a peripheral circuit region PERI separated and disposed on one substrate. That is, the memory cell region CELL and the peripheral circuit region PERI need not overlap vertically. In some cases, the memory cell region CELL may be disposed below the peripheral circuit region PERI.

The peripheral circuit region PERI may include a base substrate 201, circuit elements 220 disposed on the base substrate 201, circuit contact plugs 270 and circuit wiring lines 280 .

The base substrate 201 may have an upper surface extending in a first direction (X direction) and a second direction (Y direction). Separate element isolation layers may be disposed on the base substrate 201 to define an active region. In a part of the active region, source/drain regions 205 containing an impurity may be positioned. The base substrate 201 may include a semiconductor material, for example, a group IV semiconductor, a group III-V compound semiconductor, or a group II-VI compound semiconductor. The base substrate 201 may be provided as a bulk wafer or as an epitaxial layer, as non-limiting examples.

The circuit elements 220 may include horizontal transistors. Each of the circuit elements 220 may include a circuit gate dielectric layer 222, a spacer layer 224, and a circuit gate electrode 225. The source/drain regions 205 may be disposed on both sides of the circuit gate electrode 225.

A peripheral region insulation layer 290 may be disposed over the circuit element 220 on the base substrate 201. The circuit contact plugs 270 may be connected to the source/drain regions 205 through the peripheral region insulation layer 290.

An electrical signal may be applied to the circuit element 220 by the circuit contact plugs 270 . In a region not shown, the circuit contact plugs 270 may also be connected to the circuit gate electrode 225. The circuit wiring lines 280 may be connected to the circuit contact plugs 270 and may be disposed as a plurality of layers.

In an embodiment, in the semiconductor device 100, the peripheral circuit region PERI may be manufactured first and then the substrate 101 of the memory cell region CELL may be manufactured on the peripheral circuit region PERI such that the memory cell region CELL can be manufactured. The substrate 101 may have the same size as the base substrate 201 or may be smaller than the base substrate 201.

The memory cell region CELL may include a substrate 101, first and second horizontal conductive layers 102 and 104 disposed on the substrate 101, a stacking structure ST, a first channel structure CH1, an insulation pattern 191, and a second optional gate electrode 150. The stacking structure ST may be made of alternately stacked first gate electrodes 130 and interlayer insulation layers 120. The first channel structures CH1 may extend along a third direction (Z direction) through the stacking structure ST, and may include a first channel layer 140, respectively. An insulation pattern 191 may be disposed on the first channel structures CH1. The second select gate electrode 150 may be disposed over the insulation pattern 191. The second channel structures CH2 may extend along the third direction (Z direction) through the second selection gate electrode 150, and may include a second channel layer 170, respectively. Separation regions MS extending along the third direction (Z direction) through the stacking structure ST and upper separation regions SS extending along the third direction (Z direction) through the second channel structures CH2, the second selection gate electrode 150, and the insulation pattern 191 may be further included.

The memory cell region CELL may further include a cell region insulation layer 190 that is disposed between the insulation pattern 191 and the stacking structure ST and that covers the stacking structure ST, upper insulation layers 192, 193, 194, and 195 disposed on the cell region insulation layer 190, and an upper wire structure 180 connected to each of the second channel structures CH2.

The substrate 101 may have an upper surface extending in the first direction (X direction) and the second direction (Y direction). The substrate 101 may include a semiconductor material, for example, a group IV semiconductor, a group III-V compound semiconductor, or a group II-VI compound semiconductor. For example, a group IV semiconductor may include silicon, germanium, or silicon-germanium. The substrate 101 may be provided as a bulk wafer, an epitaxial layer, an epitaxial layer, a silicon-on insulator (SOI) layer, or a semiconductor-on Insulator (SeOI) layer, as non-limiting examples.

First and second horizontal conductive layers 102 and 104 may be stacked and disposed on the upper surface of the substrate 101. The first horizontal conductive layer 102 may function as at least a part of a common source line of the semiconductor device 100 and, for example, may function as a common source line together with the substrate 101. As shown in the enlarged view of FIG. 3, the first horizontal conductive layer 102 may be directly connected to the first channel layer 140 in circumference of the first channel layer 140.

The first and second horizontal conductive layers 102 and 104 may include a semiconductor material and, for example, may include polysilicon. In this case, at least the first horizontal conductive layer 102 may be a layer doped with impurities of the same conductivity type as the substrate 101, and the second horizontal conductive layer 104 may be a doped layer or a layer including an impurity diffused from the first horizontal conductive layer 102, as non-limiting examples. For example, the material of the second horizontal conductive layer 104 may be replaced with an insulation layer in some embodiments.

The first gate electrodes 130 may be spaced apart in a third direction (Z direction) on the substrate 101 to provide a stacking structure ST. The first gate electrodes 130 may include a first selection gate electrode 130G including a gate of a ground selection transistor and memory gate electrodes 130M including a plurality of memory cells. The number of memory gate electrodes 130M forming memory cells may be determined according to the capacity of the semiconductor device 100. For example, each of the first selection gate electrodes 130G may be one or two or more, and may have the same or different structure as the memory gate electrodes 130M.

In some embodiments, the first gate electrodes 130 may be disposed below the first selection gate electrode 130G and may further include a gate electrode including an erase transistor used for an erase operation using a gate induced leakage (GIDL) phenomenon. In addition, some first gate electrodes 130 (e.g., memory gate electrodes 130M adjacent to the first selection gate electrode 130G) may be dummy gate electrodes.

In addition, in some embodiments, the first gate electrodes 130 may further include a diffusion barrier. The diffusion barrier may include, for example, tungsten nitride (WN), tantalum nitride (TaN), titanium nitride (TiN), or a combination thereof.

The interlayer insulation layers 120 may be disposed between the first gate electrodes 130, and may be alternately disposed with the first gate electrodes 130 in the third direction (Z direction). Like the first gate electrodes 130, the interlayer insulation layers 120 may also be disposed apart from each other in the third direction (Z direction) on the upper surface of the substrate 101. The interlayer insulation layers 120 may include an insulating material such as a silicon oxide or a silicon nitride, as non-limiting examples.

The first channel structures CH1 may each include one memory cell string, and may be spaced apart from each other while including rows and columns on the substrate 101. The first channel structures CH1 may be disposed as a lattice pattern or disposed in a zigzag form in one direction on a plane where the first direction (X direction) and the second direction (Y direction) intersect. For example, the first channel structure CH1 may be disposed in a zigzag form by a plurality of channel structures (e.g., six channel structures) arranged in a first column between adjacent separation regions (MS) and a plurality channel structures (e.g., six channel structures) arranged in a second column, as non-limiting examples. The disposed form of the first channel structures CH1 may be variously changed.

Each of the first channel structures CH1 may be provided in first channel holes CH1h penetrating the stacking structure ST. Each of the first channel structures CH1 may have a column shape and may have an inclined side surface that becomes narrower closer to the substrate 101 according to an aspect ratio.

In addition to the first channel layer 140, each of the first channel structures CH1 may further include a first dielectric layer 142, a first fill insulation layer 144 between the first channel layers 140, and a first channel pad 145 on top of the first fill insulation layer 144.

The first channel layer 140 may be disposed in an annular shape surrounding the first fill insulation layer 144 inside, as a non-limiting example. In some embodiments, the first channel layer 140 may have a column shape such as a cylinder or a prism without the first fill insulation layer 144.

The first channel layer 140 may be connected to the first horizontal conductive layer 102 at the bottom. The first channel layer 140 may include a semiconductor material such as polysilicon. The semiconductor material may be an undoped material or a material including a p-type or n-type impurity.

The first dielectric layer 142 may be disposed between the first gate electrodes 130 and the first channel layer 140 .

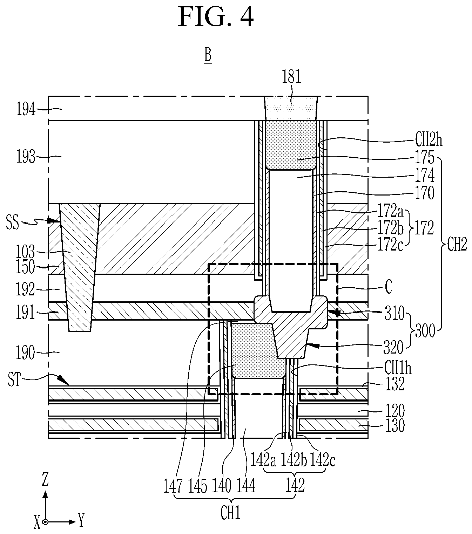

As shown in FIG. 4, the first dielectric layer 142 may include a first tunneling layer 142a, a first charge storage layer 142b, and a first blocking layer 142c that are sequentially stacked from the first channel layer 140.

The first tunneling layer 142a may tunnel charge to the first charge storage layer 142b. The first tunneling layer 142a may include, for example, a silicon oxide (SiO₂), a silicon nitride (SiNₓ), a silicon oxynitride (SiOₓN_{y}), or a combination thereof as non-limiting examples. The first charge storage layer 142b may be a charge trap layer or a floating gate conductive layer. The first blocking layer 142c may include a silicon oxide (SiO₂), a silicon nitride (SiNₓ), a silicon oxynitride (SiOₓN_{y}), a high dielectric constant (high-k) material, or a combination thereof.

In some embodiments, the semiconductor device 100 may further include a gate dielectric layer 132 disposed between the first gate electrodes 130 and the interlayer insulation layers 120 and between the first gate electrodes 130 and the first channel structure CH1. The gate dielectric layer 132 may prevent charge in the first charge storage layer 142b from moving to the first gate electrodes 130 together with the first blocking layer 142c.

The first channel pad 145 may be disposed to cover the upper surface of the first fill insulation layer 144 and be electrically connected to the first channel layer 140. The first channel pad 145 may be disposed above the first channel layer 140. The first channel pad 145 may include, for example, polysilicon.

Separation regions MS may pass through a stacking structure ST made up of a cell region insulation layer 190, first gate electrodes 130 interlayer insulation layers 120, and first and second horizontal conductive layers 102 and 104. The separation regions MS extend in a third direction (Z direction) and may be connected to the substrate 101.

As shown in FIG. 3, the separation regions MS may be spaced apart from each other along the second direction (Y direction) and disposed in parallel. The separation regions MS may separate the first gate electrodes 130 from each other in the second direction (Y direction).

The separation regions MS may have a shape of which a width decreases toward the substrate 101 due to a high aspect ratio. A separation insulation layer 105 may be disposed within the separation regions MS. The separation insulation layer 105 may include at least one of silicon oxide, silicon nitride, or silicon oxynitride, as non-limiting examples. A conductive material layer may be disposed within the separation regions MS.

A cell region insulation layer 190 may cover the stacking structure ST made up of the first gate electrodes 130 and the interlayer insulation layers 120. The cell region insulation layer 190 may cover at least a part of side surfaces of the separation regions MS and/or first channel structures CH1, for example, a portion extending upward from the stacking structure ST.

In some embodiments, an upper surface of the cell region insulation layer 190 may be disposed at substantially the same level as an upper surface of each of the first channel structures CH1. Moreover, the upper surface of the cell region insulation layer 190 may be disposed at substantially the same level as the upper surface of each of the separation regions MS.

The cell region insulation layer 190 may include at least one of silicon oxide, silicon nitride, or silicon oxynitride, as non-limiting examples.

The insulation pattern 191 may be disposed on the stacking structure ST. That is, the insulation pattern 191 may be disposed on the first channel structures CH1 and the separation regions MS. The insulation pattern 191 has a penetration, or through, portion exposing at least a part of the first channel structure CH1. The insulation pattern 191 may cover the first channel structures CH1. The insulation pattern 191 may be disposed at a higher level than that of the stacking structure ST and the cell region insulation layer 190. The insulation pattern 191 may have a conformal thickness and may extend in the first direction (X direction) and the second direction (Y direction).

A thickness of the insulation pattern 191 may be substantially equal to, or smaller than, a thickness of the first gate electrode 130. The insulation pattern 191 may include a material different from that of the cell region insulation layer 190. The insulation pattern 191 may include a material having an etching rate for a first upper insulation layer 192 and the cell region insulation layer 190 to be described later. For example, the insulation pattern 191 may include a silicon nitride, as non-limiting examples.

The insulation pattern 191 may have an integral structure in which parts except for a second channel hole CH2h to be described later are connected to each other on a plane made up of the first direction (X direction) and the second direction (Y direction). This pattern may simplify the process of connecting the first channel structure CH1 and the second channel structure CH2 by forming a plurality of penetrating portions in the insulation pattern 191 of the single layer and forming the contact pattern 300 in the penetrating part.

In addition, the insulation pattern 191 may be penetrated by an upper separation region SS to be described later. Accordingly, although the insulation pattern 191 of the semiconductor device 100 according to an embodiment has an integral structure connected to each other on a plane, residual material generated during the manufacturing process may be discharged through the upper separation region SS.

Each of the first channel structures CH1 may further include a capping pad 147. The capping pad 147 may be disposed between the insulation pattern 191 and the first channel pad 145. An upper surface of the capping pad 147 may be disposed at substantially the same level as the upper surface of the cell region insulation layer 190, and may be disposed at substantially the same level as the lower surface of the insulation pattern 191.

The capping pad 147 may have a thinner thickness than the insulation pattern 191 . The capping pad 147 may include a material different from that of the insulation pattern 191 . For example, the capping pad 147 may include an oxide-based material such as silicon oxide as non-limiting examples, and the material included in the capping pad 147 may be variously changed.

Each of the first channel structures CH1 of the semiconductor device according to an embodiment has been described as including the capping pad 147. However, this arrangement is not restrictive, and the capping pad 147 may be omitted. In this case, an upper surface of the first channel pad 145 may be disposed at substantially the same level as the upper surface of the cell region insulation layer 190 and may contact a lower surface of the insulation pattern 191.

The second selection gate electrode 150 is disposed on the insulation pattern 191. That is, the second selection gate electrode 150 may be disposed at a higher level than the first channel structures CH1.

In addition, in some embodiments, the second selection gate electrode 150 may include a material that is different from that of the first gate electrodes 130. For example, the second selection gate electrode 150 may be a semiconductor material layer such as polysilicon. However, in some implementations, the first gate electrode 130 may include at least one of a doped semiconductor material, a metal (e.g., TiN, TaN), and a transition metal (e.g., Ti, Ta). In this case, a thickness of the second selection gate electrode 150 may be thicker than a thickness of each of the first gate electrodes 130.

The second selection gate electrode 150 may be a string selection line including string selection transistors (refer to UT1 and UT2 in FIG. 28).

A first upper insulation layer 192 may be disposed between the second selection gate electrode 150 and the insulation pattern 191. The second selection gate electrode 150 may be spaced apart from the insulation pattern 191 by the first upper insulation layer 192.

The first upper insulation layer 192 may have a thicker thickness than that of the insulation pattern 191. The first upper insulation layer 192 may include, for example, a silicon oxide.

The second to fourth upper insulation layers 192, 193, and 194 may be sequentially stacked on the second selection gate electrode 150. The second to fourth upper insulation layers 192, 193, and 194 may include at least one of a silicon oxide, a silicon nitride, and a silicon oxynitride.

Upper separation regions SS may pass through the second selection gate electrode 150 and the insulation pattern 191. The upper separation regions SS may extend in the first direction (X direction). Upper surfaces of the upper separation regions SS may be disposed at substantially the same level as an upper surface of the second selection gate electrode 150. The upper separation regions SS may pass through the second selection gate electrode 150 and the insulation pattern 191 and extend into the cell region insulation layer 190. Lower surfaces of the upper separation regions SS may be disposed at a higher level than the stacking structure ST.

In the semiconductor device 100 according to an embodiment, the interval between adjacent separation regions MS in the second direction (Y direction) may be greater than the interval between adjacent upper separation regions (SS) in the second direction (Y direction). That is, on a plane, at least some of the upper separation regions SS may be positioned between adjacent separation regions MS.

Since the upper separation regions SS and the second selection gate electrode 150 are disposed at a higher level than the separation regions MS and the first channel structure CH1, dummy structures between the first channel structures CH1 may be omitted, and thus a semiconductor device 100 with improved integration can be provided.

An upper separation insulation layer 103 may be disposed within the upper separation regions SS. The upper separation insulation layer 103 may include an insulating material such as a silicon oxide, as a non-limiting example. However, embodiments are not limited thereto. In some embodiments, the upper separation regions SS may include at least some of the materials of the second channel structures CH2 to be described later.

Each of the second channel structures CH2 may be provided in a second channel hole CH2h penetrating the second selection gate electrode 150. Each of the second channel structures CH2 may be extended in a third direction (Z direction) and electrically connected to each of the first channel structures CH1. The second channel structures CH2 may be a string selection channel structure of string selection transistors (refer to UT1 and UT2 in FIG. 28). The second channel structure CH2 will be described later with reference to FIG. 4 to FIG. 7.

The upper wire structure 180 includes a conductive material and may be electrically connected to the first and second channel structures CH1 and CH2. The upper wire structure 180 may include studs 181, contact plugs 182, and an upper wire 183. The studs 181 may pass through the third upper insulation layer 194 and contact the upper surface of each of the second channel structures CH2.

In FIG. 2, although a planar area of each of the studs 181 is smaller than a planar area of each of the second channel structures CH2s, this is for illustrative purposes of describing the studs 181, and the planar area of each of the studs 181 may be substantially the same as or smaller than the planar area of each of the second channel structures CH2.

The contact plugs 182 may pass through the fourth upper insulation layer 195 and be connected to the studs 181. The upper wire 183 may be disposed over the contact plugs 182 and the fourth upper insulation layer 195. A part of the upper wire 183 may be bit lines (refer to BL in FIG. 28) contacting the contact plugs 182. As shown in FIG. 1 and FIG. 2, the bit lines may extend in the second direction (Y direction) crossing the first direction (X direction) in which the upper separation regions SS extend. The bit lines may be electrically connected to the second channel structures CH2 through the contact plugs 182.

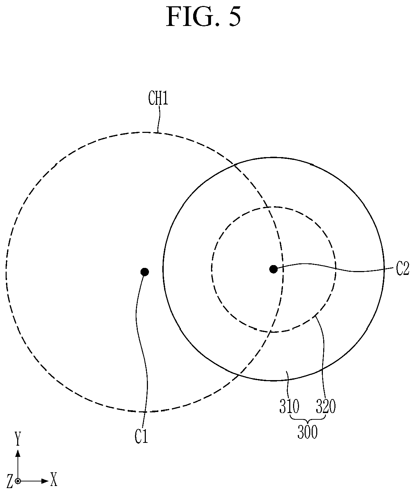

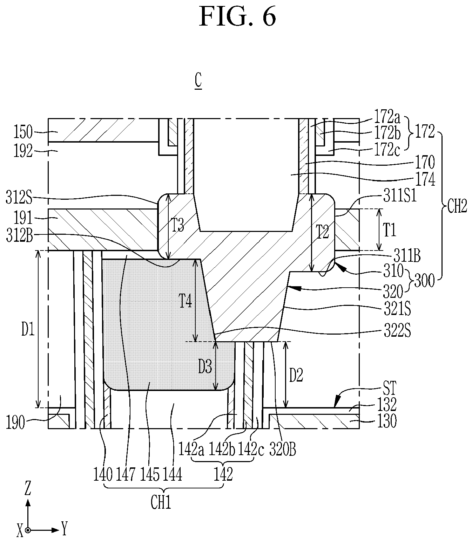

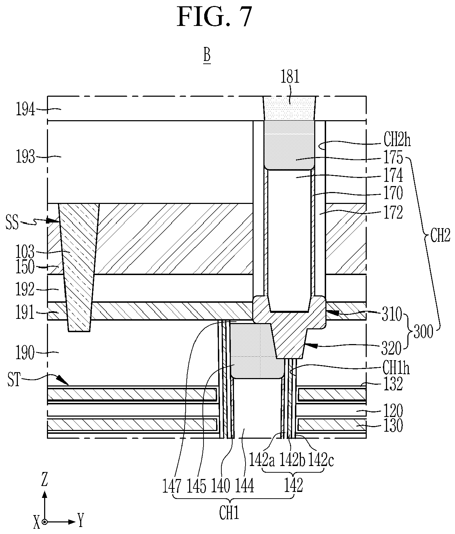

FIG. 4 is an enlarged cross-sectional view of the region B in FIG. 3. FIG. 5 is a schematic top plan view of a channel structure of the semiconductor device according to an embodiment. FIG. 6 is an enlarged cross-sectional view of the region C in FIG. 4. FIG. 7 is a cross-sectional view corresponding to the region B of FIG. 3, which shows the semiconductor device according to an embodiment.

Referring to FIG. 4 to FIG. 6, each of the second channel structures CH2 may be provided in a second channel hole CH2h penetrating the second selection gate electrode 150. An inner surface of the second channel hole CH2h may be defined by the first upper insulation layer 192, the second selection gate electrode 150, and the second upper insulation layer 193. A bottom surface of the second channel hole CH2h may be disposed at a lower level than a bottom surface of the second selection gate electrode 150. Each of the second channel structures CH2 may contact an upper surface of the first channel structure CH1. An upper surface of each of the second channel structures CH2 may be covered by a third upper insulation layer 194.

Each of the second channel structures CH2 may have a column shape. Unlike the above-described first channel structures CH1, a width of each of the second channel structures CH2 may be constant. That is, a width of the upper surface and a width of the bottom surface of each of the second channel structures CH2 may be the same. However, this is not restrictive, and in some embodiments, the second channel structures CH2 may include inclined sides that become narrower closer to the substrate 101 .

The second channel structure CH2 may be spaced apart from each other while including rows and columns on the insulation pattern 191. The second channel structure CH2 may be disposed to form a lattice pattern on a plane where the first direction (X direction) and the second direction (Y direction) intersect or may be disposed in a zigzag form in one direction.

At least a part of the second channel structure CH2 may overlap the first channel structure CH1 in the third direction (Z direction). For example, some regions of each of the second channel structures CH2 may overlap the first channel structure CH1, and remaining regions may overlap the cell region insulation layer 190. That is, on a plane, a center of each second channel structure CH2 may be spaced apart from a center of each of the first channel structure CH1 in the second direction (Y direction).

A width of the second channel structure CH2 may be smaller than a width of the first channel structure CH1. For example, the width of the second channel structure CH2 along the second direction (Y direction) may be smaller than the width (for example, in plan-view from above) of the first channel structure CH1 along the second direction (Y direction). As a result, the second channel structure CH2 can be stably disposed on the first channel structure CH1. However, the embodiment is not limited thereto, and the width of the second channel structure CH2 may be equal to or greater than the width of the first channel structure CH1.

Each of the second channel structure CH2 includes a contact pattern 300, and may include a second channel layer 170, a second dielectric layer 172, a second fill insulation layer 174 between the second channel layers 170, and a second channel pad 175 on the second fill insulation layer 174.

The contact pattern 300 may pass through the insulation pattern 191 and is connected to the first channel structures CH1. The contact pattern 300 may partially overlap with the first channel structures CH1 in the third direction (Z direction), which is the vertical direction. For example, some regions of the contact pattern 300 may overlap each of the first channel structures CH1, and the remaining regions may overlap the cell region insulation layer 190. That is, on a plane, a center of the contact pattern 300 may be spaced apart from a center of each of the first channel structures CH1 in the second direction (Y direction).

The contact pattern 300 may include the same material as the second channel layer 170. For example, the contact pattern 300 may include a semiconductor material such as polysilicon, and the semiconductor material may be an undoped material or a material including a p-type or n-type impurity. However, this is not restrictive, and the contact pattern 300 may include a material different from that of the second channel layer 170.

The contact pattern 300 may overlap the second channel layer 170 in the third direction (Z direction).

The contact pattern 300 includes a first portion 310 penetrating the insulation pattern 191 and disposed on the first channel pad 145, and a second portion 320 disposed on the first dielectric layer 142 protruded toward the substrate from the inside of the bottom surface of the first portion 310.

The first portion 310 of the contact pattern 300 is disposed on an upper surface of the first channel pad 145. The first portion 310 of the contact pattern 300 includes a portion disposed within a penetration portion of the insulation pattern 191. The first portion 310 of the contact pattern 300 may partially overlap the first channel structures CH1 in the vertical third direction (Z direction). For example, as shown in FIG. 5, a portion of the first portion 310 may overlap each of the first channel structures CH1, and the remaining portion may overlap the cell region insulation layer 190. That is, on a plane, a center C2 of the first portion 310 of the contact pattern 300 may be spaced apart from a center C1 of each of the first channel structure CHls in the second direction (Y direction).

The first portion 310 includes a portion disposed within the penetration portion on the upper surface of the first channel pad 145. For example, one side of the first portion 310 may be disposed on the cell region insulating layer. The other side of the first portion 310 may be disposed on the first channel pad 145.

The first portion 310 may include an extension portion extending outward from an edge of the second portion at an upper portion of a second portion, which will be described later. For example, the first portion 310 may be disposed on the cell region insulation layer 190. One side of the first portion 310 may be disposed on the cell region insulation layer 190. The extension portion of the first portion 310 may be disposed above the bottom surface 320B of the second portion 320. That is, the extension portion of the first portion 310 may be disposed at a level higher than a bottom surface 320B of the second portion 320.

In summary, one side of the first portion 310 may be disposed on the cell region insulation layer 190, and the other side of the first portion 310 may be disposed on the first channel pad 145. Hereinafter, one side of the first portion 310 may be a portion disposed on the cell region insulation layer 190, and the other portion of the first portion 310 may be a portion disposed on the first channel pad 145. Accordingly, since the first portion of the contact pattern 300 includes the penetration portion and the extension portion, it can be easily filled in the recess of the first channel pad 145 to be described later. In addition, the penetration portion may be filled without an air gap by the first portion 310 or the second channel structure CH2.

A bottom surface of the first portion 310 may overlap each of the cell region insulation layer 190 and the first channel structure CH1 in the third direction (Z direction). For example, a bottom surface 311B on one side of the first portion 310 overlaps the cell region insulation layer 190 in the third direction (Z direction), and a bottom surface 312B on the other side of the first portion 310 may overlap the first channel pad 145, the first channel layer 140, and the first dielectric layer 142 in the third direction (Z direction). Accordingly, the bottom surface 312B of the other side of the first portion 310 may be electrically connected to the first channel pad 145.

The bottom surface 311B of one side of the first portion 310 may be positioned closer to the stacking structure ST than the bottom surface 312B on the other side of the first portion 310. For example, the bottom surface 311B of one side of the first portion 310 may be positioned closer to the top surface of the uppermost gate electrode among the first gate electrodes 130 than the bottom surface 312B on the other side of the first portion 310 .

An upper surface of the first portion 310 may overlap the first upper insulation layer 193 and the second channel structure CH2 in the third direction (Z direction). For example, a portion of the upper surface of the first portion 310 overlaps the first upper insulation layer 193 in the third direction (Z direction), and the remaining portion of the upper surface of the first portion 310 overlaps with the second fill insulation layer 174, the second channel layer 170, and the second dielectric layer 172 in the third direction (Z direction). In addition, the upper surface of the first portion 310 disposed on the cell region insulation layer 190 and the upper surface of the first portion 310 disposed on the first channel pad 145 may be positioned at substantially the same level.

Accordingly, a second thickness T2 of one portion of the first portion 310 positioned on the cell region insulation layer 190 according to the third direction (Z direction) may be greater than a third thickness T3 of the other portion of the first portion 310 positioned on the first channel pad 145 according to the third direction (Z direction). Accordingly, the contact pattern 300 may be easily filled in the process of forming the contact pattern 300 by forming the thickness of the other side of the first portion 310 thick.

The thickness of the first portion 310 according to the third direction (Z direction) may be greater than the third thickness T3 of the insulation pattern 191 according to the third direction (Z direction). For example, the thickness of the extension portion of the first portion 310 may be greater than the thickness of the insulation pattern 191. For example, the second thickness T2 according to the third direction (Z direction) of one side of the first portion 310 disposed on the cell region insulation layer 190 may be greater than the first thickness T1 according to the third direction (Z direction) of the insulation pattern 191. In addition, the third thickness T3 according to the third direction (Z direction) of the other side of the first portion 310 disposed on the first channel pad 145 may be greater than the first thickness T1 according to the third direction (Z direction) of the insulation pattern 191.

Accordingly, the upper surface of the first portion 310 may be disposed closer to the second selection gate electrode 150 than the upper surface of the insulation pattern 191. That is, the upper surface of the first portion 310 may be disposed at a higher level than the upper surface of the insulation pattern 191. In addition, the bottom surface 311B on one side of the first portion 310 and the bottom surface 312B on the other side of the first portion 310 may be positioned closer to the stacking structure ST than the bottom surface of the insulation pattern 191, respectively. That is, each of the bottom surface 311B on one side of the first portion 310 and the bottom surface 312B on the other side of the first portion 310 may be positioned at a level lower than the bottom surface of the insulation pattern 191.

A side surface of the first portion 310 may overlap the insulation pattern 191 in the second direction (Y direction). For example, a first side 311S on one side of the first portion 310 may be in contact with the side of the insulation pattern 191, the first upper insulation layer 192, and the cell region insulation layer 190, and a second side 312S of the other side of the first portion 310 may be in contact with the side of the insulation pattern 191, the first upper insulation layer 192, and the capping pad 147.

The second portion 320 of the contact pattern 300 may be protruded toward the substrate from inside the bottom surface of the first portion 310. The second portion 320 of the contact pattern 300 may be disposed such that recesses are provided in the first channel pad 145 and the first dielectric layer 142. As shown in FIG. 5, the recess may have a circular shape on a plane made up of a first direction (X direction) and a second direction (Y direction). In addition, as shown in FIG. 6, the recess may have a trapezoid shape on a cross-section made up of the second direction (Y direction) and the third direction (Z direction). That is, the second portion 320 of the contact pattern 300 may have a pillar shape with an inclined side surface that becomes narrower closer to the substrate 101 according to an aspect ratio. However, it is not limited thereto, and the second portion 320 of the contact pattern 300 may have a column shape having a constant width according to an aspect ratio.

The second portion 320 of the contact pattern 300 may partially overlap the first channel structures CH1 in the third direction (Z direction), which is a vertical direction. For example, a portion of the second portion 320 may overlap the first channel pad 145, the first channel layer 140, and the first dielectric layer 142, and the remaining portion may overlap the cell region insulation layer 190. That is, on a plane, the center of the second portion 320 of the contact pattern 300 may be spaced apart from the center of each of the first channel structures CH1 in the second direction (Y direction).

The second portion 320 of the contact pattern 300 may be disposed on the first dielectric layer 142. In addition, the second portion 320 of the contact pattern 300 may be disposed between the first channel pad 145 and the cell region insulation layer 190. That is, the second portion 320 of the contact pattern 300 may be disposed between the first portion 310 of the contact pattern 300 and the first dielectric layer 142 and between the first channel pad 145 and the cell region insulation layer 190.

The bottom surface 320B of the second portion 320 may overlap the first dielectric layer 142 and the first channel pad 145. The bottom surface 320B of the second portion 320 may contact the first dielectric layer 142 and the first channel pad 145. For example, a portion where the bottom surface 320B of the second portion 320 is disposed on the first dielectric layer 142 and a portion where the bottom surface 320B of the second portion 320 is disposed on the first channel pad 145 may be positioned on the same plane. That is, the-above stated portions may be disposed on the same plane through a process of simultaneously etching the first dielectric layer 142 and the first channel pad 145. That is, even when the contact pattern 300 overlaps with the first dielectric layer 142 along the third direction (Z direction), it means that the first dielectric layer 142 may be etched at the same level as the first channel pad 145. Therefore, in the process of forming the second portion 320 of the contact pattern 300 of the semiconductor device 100 according to an embodiment, the first dielectric layer 142 is etched such that the second portion 320 can be prevented from being extended in the third direction (Z direction) along the sidewall of the first channel layer 140. Accordingly, it is possible to prevent the second portion 320 from being electrically connected to the first gate electrodes 130.

The bottom surface 320B of the second portion 320 may be disposed closer to the stacking structure ST than the bottom surface of the insulation pattern 191. That is, a first distance D1 from the top surface of the stacking structure ST to the bottom surface of the insulation pattern 191 may be greater than a second distance D2 from the top surface of the stacking structure ST to the bottom surface 320B of the second portion 320. The bottom surface 320B of the second portion 320 may be disposed at a level lower than the bottom surface of the insulation pattern 191. In addition, the second distance D2 from the top surface of the stacking structure ST to the bottom surface 320B of the second portion 320 may be greater than a third distance D3 from the bottom surface of the first channel pad 145 to the bottom surface 320B of the second portion 320. Since the bottom surface 320B of the second portion 320 is spaced apart from the top surface of the stacking structure ST by the second distance D2, the second portion 320 of the contact pattern 300 may not be electrically connected to the first gate electrodes 130 of the stacking structure ST.

In addition, the bottom surface 320B of the second portion 320 may be disposed closer to the stacking structure ST than the bottom surface of the first portion 310. For example, the bottom surface 320B of the second portion 320 may be disposed closer to the stacking structure ST than the bottom surface 311B on one side of the first portion 310 disposed on the cell region insulation layer 190. In addition, the bottom surface 320B of the second portion 320 may be disposed closer to the stacking structure ST than the bottom surface 312B of the other side of the first portion 310 disposed on the first channel pad 145.

When the distance along the third direction (Z direction) from the bottom surface 312B of the other side of the first portion 310 to the bottom surface 320B of the second portion 320 is defined as a fourth thickness T4 of the second portion 320, the fourth thickness T4 of the second portion 320 may be greater than a thickness of the first portion 310 according to the third direction (Z direction). Specifically, the fourth thickness T4 of the second portion 320 may be greater than the second thickness T2 along the third direction (Z direction) of one side of the first portion 310 disposed on the cell region insulation layer 190. In addition, the fourth thickness T4 of the second portion 320 may be larger than the third thickness T3 according to the third direction (Z direction) of the other side of the first portion 310 disposed on the first channel pad 145 .

Some side surfaces of the second portion 320 may overlap the first channel pad 145 in the second direction (Y direction). For example, the first side 321S of the second portion 320 may overlap the cell region insulation layer 190, and the second side 322S of the second portion 320 may overlap the first channel pad 145. Accordingly, the second side surface 322S of the second portion 320 may be electrically connected to the first channel pad 145.

In summary, as a part of the bottom surface 320B of the second portion 320 and the second side surface 322S of the second portion 320 contact the first channel pad 145, the contact area between the second portion 320 and the first channel pad 145 may increase. In other words, since the contact area between the contact pattern 300 and the first channel pad 145 increases, the first channel structure CH1 and the second channel structure CH2 can be stably connected. Therefore, the reliability of the semiconductor device 100 can be secured.

The second channel layer 170 may be disposed on the contact pattern 300. The second channel layer 170 may be disposed in an annular shape surrounding the second fill insulation layer 174 therein. However, it is not limited thereto, and in some embodiments, the second channel layer 170 may have a column shape such as a cylinder or a prism without the second fill insulation layer 174. The second channel layer 170 may be connected to the contact pattern 300 at the bottom. The second channel layer 170 may include a semiconductor material such as polysilicon, and the semiconductor material may be an undoped material or a material including a p-type or n-type impurity.

In addition, the second channel layer 170 may extend from the inside of the second channel hole CH2h in the third direction (Z direction) to contact the first upper insulation layer 192.

The second channel layer 170 may be connected to the contact pattern 300 to form an integral body. The second channel layer 170 and the contact pattern 300 may be formed together, and an interface may not exist between the second channel layer 170 and the contact pattern 300. However, it is not limited thereto, and in some embodiments, the second channel layer 170 and the contact pattern 300 may be formed by a separate process, and when the second channel layer 170 and the contact pattern 300 are formed by a separate process, an interface may be formed between the second channel layer 170 and the contact pattern 300.

The second dielectric layer 172 may be disposed between the second selection gate electrode 150 and the second channel layer 170. In some embodiments, the second dielectric layer 172 may include a similar structure or same material as the first dielectric layer 142. For example, the first dielectric layer 142 and the second dielectric layer 172 may have a multilayer structure.

As shown in FIG. 6, the second dielectric layer 172 may include a second tunneling layer 172a, a second charge storage layer 172b, and a second blocking layer 172c sequentially stacked from the second channel layer 170.

The second tunneling layer 172a may tunnel charge to the second charge storage layer 172b, and may include, for example, a silicon oxide (SiO₂), a silicon nitride (SiNₓ), a silicon oxynitride (SiOₓN_{y}), or a combination thereof. However, this is not restrictive.

The second charge storage layer 172b may be a charge trap layer or a floating gate conductive layer. The second layer 172c may include a silicon oxide (SiO₂), a silicon nitride (SiNₓ), a silicon oxynitride (SiOₓN_{y}), a high dielectric constant (high-k) material, or a combination thereof.

In the drawing, the case where the second dielectric layer 172 is multi-layered has been described, but is not limited thereto, and the second dielectric layer 172 may include a structure different from that of the first dielectric layer 142 or a different material. For example, as shown in FIG. 7, when the first dielectric layer 142 has a multilayer structure, the second dielectric layer 172 may be a single layer. The second dielectric layer 172 may include, for example, a silicon oxide (SiO₂), a silicon nitride (SiNₓ), a silicon oxynitride (SiOₓN_{y}), or a combination thereof. However, this is not restrictive.

The second channel pad 175 may be disposed to cover the upper surface of the second fill insulation layer 174 and be electrically connected to the upper surface of the second channel layer 170. The second channel pad 175 may be disposed above the second channel layer 170. The second channel pad 175 may include, for example, polysilicon.

The first channel structures CH1 and the second channel structures CH2 of the semiconductor device 100 according to an embodiment may be alternately disposed in the second direction (Y direction). Accordingly, at least some of the second channel structures CH2 may include a portion that does not overlap with the first channel structures CH1 in the third direction (Z direction). However, even in this case, the first channel structure CH1 and the second channel structures CH2 need to be electrically connected to each other.

In the semiconductor device 100 according to an embodiment, the first portion 310 of the contact pattern 300 is disposed on the first channel pad 145, and thus the first portion 310 of the contact pattern 300 may contact the first channel pad 145. In addition, as the second portion 320 of the contact pattern 300 is protruded from the first portion 310 toward the substrate 101 and disposed on the first dielectric layer 142, a side surface of the second portion 320 may come into contact with the first channel pad 145. Accordingly, although at least some of the second channel structures CH2 does not overlap with the first channel structures CH1 in the third direction (Z direction), the contact area of the first channel pad 145 and the contact pattern 300 can be secured. Therefore, the reliability of the semiconductor device 100 can be secured.

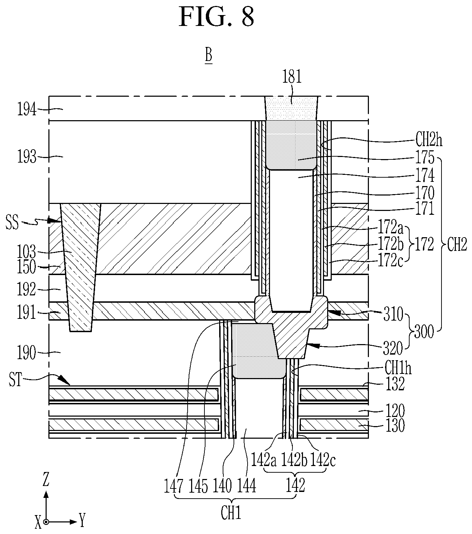

Hereinafter, a semiconductor device according to an embodiment will be described with reference to FIG. 8.

FIG. 8 is a cross-sectional view that corresponds to the region B of FIG. 3, which shows a semiconductor device according to an embodiment.

An embodiment shown in FIG. 8 is significantly similar to the embodiment shown in FIG. 1 to FIG. 6, the description thereof will be omitted and the difference will be mainly described. The present embodiment differs from the previous embodiment in that each of the second channel structures CH2 includes a semiconductor spacer layer, which will be described below.

A memory cell region CELL of a semiconductor device 100 according to an embodiment may include a substrate 101, a stacking structure ST, first channel structures CH1, separation regions MS, an insulation pattern 191, a second selection gate electrode 150, second channel structures CH2 including a semiconductor spacer layer 171, a second selection gate electrode 150, and upper separation regions SS.

In the previous embodiment, each of the second channel structure CH2 includes a contact pattern 300, a second channel layer 170, a second dielectric layer 172, a second fill insulation layer 174 between the second channel layer 170, and a second channel pad 175 on the second fill insulation layer 174.

Referring to FIG. 8, in the present embodiment, the semiconductor spacer layer 171 may be further disposed between the second channel layer 170 and the second dielectric layer 172.

The semiconductor spacer layer 171 may be a layer covering a part of the exterior side of the second channel layer 170. The semiconductor spacer layer 171 has a conformal thickness and may be interposed between the second dielectric layer 172 and the second channel layer 170 . A lower end of the semiconductor spacer layer 171 may be disposed at a higher level than the insulation pattern 191. The second tunnelling layer 172a of the second dielectric layer 172 may contact a portion of a side surface of the second channel layer 170 while covering the bottom of the semiconductor spacer layer 171 .

A lower end of the semiconductor spacer layer 171 may be disposed at a level lower than a lower surface of the second selection gate electrode 150, but this is not restrictive, and in some embodiments, it may be substantially disposed at the same level as the lower surface of the second selection gate electrode 150.

The semiconductor spacer layer 171 may be a spacer structure for an anisotropic etching process for forming the contact pattern 300, and may serve as a channel layer together with the second channel layer 170. The semiconductor spacer layer 171 may include a semiconductor material such as silicon. For example, when the semiconductor spacer layer 171 and the second channel layer 170 include the same material, interfaces between the two components may not be distinguished. However, in some embodiments, the semiconductor spacer layer 171 may be omitted or may be replaced with a separate spacer layer other than semiconductor.

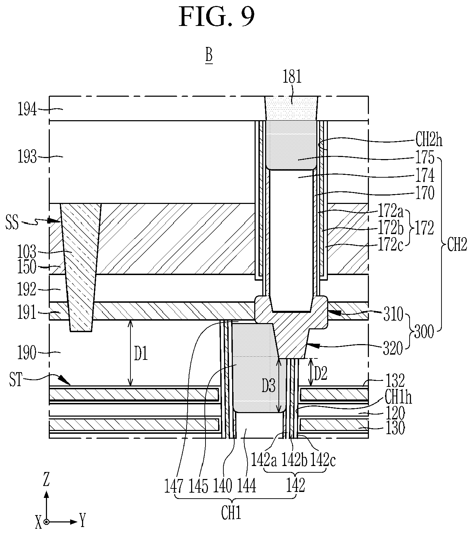

Hereinafter, a semiconductor device according to an embodiment will be described with reference to FIG. 9.

FIG. 9 is a cross-sectional view corresponding to the region B of FIG. 3, which shows a semiconductor device according to an embodiment.

An embodiment shown in FIG. 9 is considerably similar to the embodiment of FIG. 1 to FIG. 6, and therefore the description thereof will be omitted and the difference will be mainly described. In the present embodiment, a first channel pad 145 is different from the previous embodiment in that it overlaps with a stacking structure in a third direction (Z direction), which will be described below.

A memory cell region CELL of a semiconductor device 100 according to an embodiment may include a substrate 101, a stacking structure ST, first channel structures CH1, separation regions MS, an insulation pattern 191, a second selection gate electrode 150, second channel structures CH2, a second selection gate electrode 150, and an upper separation regions SS.

In the previous embodiment, the first channel pad 145 may be disposed on the stacking structure ST and need not overlap with the stacking structure ST in a second direction (Y direction).

In the present embodiment, the first channel pad 145 may overlap the stacking structure ST in the second direction (Y direction). For example, the first channel pad 145 may overlap the first gate electrodes 130 in the second direction (Y direction). That is, a bottom surface of the first channel pad 145 may be disposed at a lower level than an upper surface of the uppermost gate electrode among the first gate electrodes 130.

Accordingly, a second distance D2 from a top surface of the stacking structure ST to a bottom surface 320B of a second portion 320 may be smaller than a third distance D3 from a bottom surface of the first channel pad 145 to the bottom surface 320B of the second portion 320. However, even in this case, the second portion 320 of the contact pattern 300 may be positioned apart from the first gate electrode 130 in a third direction.

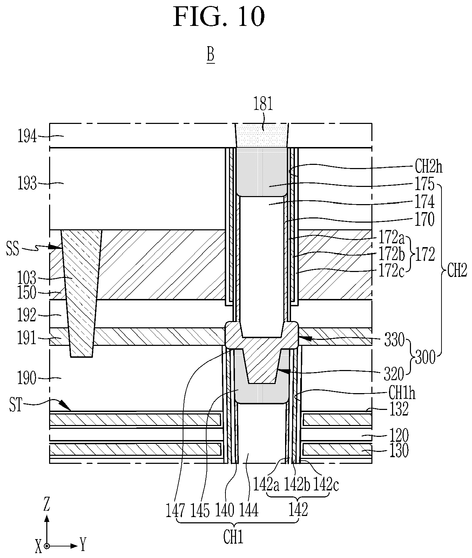

Hereinafter, a semiconductor device according to an embodiment will be described with reference to FIG. 10.

FIG. 10 is a cross-sectional view corresponding to the region B of FIG. 3, which shows a semiconductor device according to an embodiment.

An embodiment shown in FIG. 10 is considerably similar to the embodiment of FIG. 1 to FIG. 6, and therefore the description thereof will be omitted and the difference will be mainly described. In the present embodiment, a part where a first channel pad 145 overlaps with a second channel structure CH2 in a second third direction (Z direction) is different from the previous embodiment, and will be described below.

A memory cell region CELL of a semiconductor device 100 according to an embodiment may include a substrate 101, a stacking structure ST, first channel structures CH1, separation regions MS, an insulation pattern 191, a second selection gate electrode 150, second channel structures CH2, a second selection gate electrode 150, and an upper separation regions SS.

Referring to FIG. 10, in the present embodiment, a second channel structure CH2 overlapping each of the first channel structures CH1 in a third direction (Z direction) but not overlapping the cell region insulation layer 190 in a third direction (Z direction) may be further included. This is different from the previous embodiment in which each of the second channel structures CH2 overlaps the first channel structure CH1 and cell region insulation layer 190 in the third direction.

Each of the second channel structures CH2 may include a contact pattern 300, a second channel layer 170, a second dielectric layer 172, a second fill insulation layer 174 between the second channel layer 170, and a second channel pad 175 on the second fill insulation layer 174.

The contact pattern 300 may pass through the insulation pattern 191 and be connected to first channel structures CH1. The contact pattern 300 may overlap with the first channel structures CH1 in the third direction (Z direction), which is the vertical direction. The contact pattern 300 may overlap each of the first channel structures CH1 and may not overlap the cell region insulation layer 190 in the third direction (Z direction). That is, on a plane, the contact pattern 300 may completely overlap each of the first channel structures CH1.

The contact pattern 300 may include a third portion 330 (alternative to first portion 310), disposed on the first channel pad 145 passing through the insulation pattern 191 and a second portion 320 protruding from the inside of the bottom surface of the third portion 330 toward the substrate.

The third portion 330 of the contact pattern 300 may be disposed on the first dielectric layer 142 and the first channel pad 145. For example, the third portion 330 may be disposed on the first dielectric layer 142 and the first channel pad 145 . That is, a bottom surface of the third portion 330 may overlap the first dielectric layer 142 and the first channel pad 145 in a third direction (Z direction). Accordingly, a bottom surface of one side of the third portion 330 may be disposed at substantially the same level as the bottom surface of the other side of the third portion 330.

A side surface of the third portion 330 may overlap with the insulation pattern 191 in a second direction (Y direction). For example, a side surface of the third portion 330 may come into contact with a side surface of the insulation pattern 191, the first upper insulation layer 192, and the first dielectric layer 142.

The second portion 320 of the contact pattern 300 may be protruded toward the substrate from inside the bottom surface of the third portion 330. The second portion 320 of the contact pattern 300 has a pillar shape and may have an inclined side surface that narrows as it approaches the substrate 101 according to an aspect ratio. However, it is not limited thereto, and the second portion 320 of the contact pattern 300 may have a column shape having a constant width according to an aspect ratio.

The second portion 320 of the contact pattern 300 may overlap the first channel structures CH1 in the vertical third direction (Z direction). For example, the second portion 320 of the contact pattern may overlap the first channel pad 145 and may not overlap the first channel layer 140, the first dielectric layer 142, and the cell region insulation layer 190. That is, on a plane, the second portion 320 of the contact pattern 300 may completely overlap the first channel pad 145.

The second portion 320 of the contact pattern 300 may be filled in the first channel pad 145. Side and bottom surfaces of the second portion 320 of the contact pattern 300 may contact the first channel pad 145 .

Even in the case of the semiconductor device 100 according to an embodiment, the bottom surface of the third portion 330 and the side surface and bottom surface of the second portion 320 of the contact pattern 300 may contact the first channel pad 145 . Accordingly, contact areas of the first channel pad 145 and the contact pattern 300 can be secured (or maximised). Therefore, the reliability of the semiconductor device 100 can be secured.

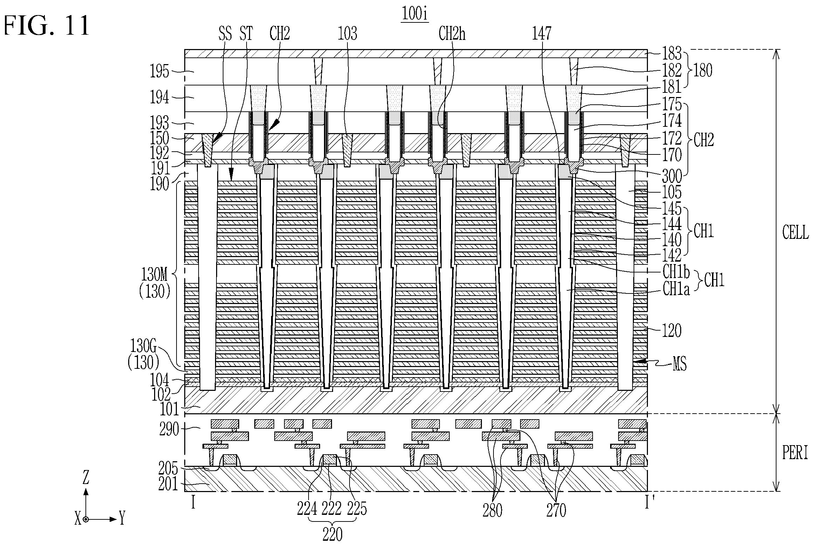

Hereinafter, other embodiments of the semiconductor device will be described with reference to FIG. 11. In the following embodiment, the same reference numerals refer to the same configuration as the previously described embodiment, and redundant descriptions will be omitted or simplified, and the differences will be mainly described.

FIG. 11 is a cross-sectional view of a semiconductor device according to an embodiment. FIG. 11 shows the portion of FIG. 1, taken along the line I-I'.

Referring to FIG. 11, in a semiconductor device 100i, a stacking structure of a first gate electrodes 130 is made up of vertically stacked lower and upper stacking structures, and a first channel structure CH1 may be made up of vertically stacked lower and upper channel structures CH1a and CH1b. Such a structure of the first channel structures CH1 may be introduced to stably provide the first channel structures CH1 when the number of first gate electrodes 130 stacked is relatively large. Depending on embodiments, the number of stacked first channel structures may be variously changed.

Each of the first channel structures CH1 may have a form in which a lower channel structure CH1a and an upper channel structure CH1b are connected, and may have a bent portion due to a difference in width in a connection region. The first channel layer 140, the first dielectric layer 142, and the first fill insulation layer 144 may be connected to each other between the lower channel structure CH1a and the upper channel structure CH1b. The first channel pad 145 may be disposed on the upper channel structure CH1b. However, depending on embodiments, the lower channel structure CH1a and the upper channel structure CH1b may each include a first channel pad 145. In this case, the first channel pad 145 of the lower channel structure CH1a may be connected to the first channel layer 140 of the upper channel structure CH1b.

At the top of the lower stacking structure, an upper interlayer insulation layer with a relatively thick thickness may be disposed. However, it is not limited thereto, and the shape of the upper interlayer insulation layer may be variously changed in the embodiments.

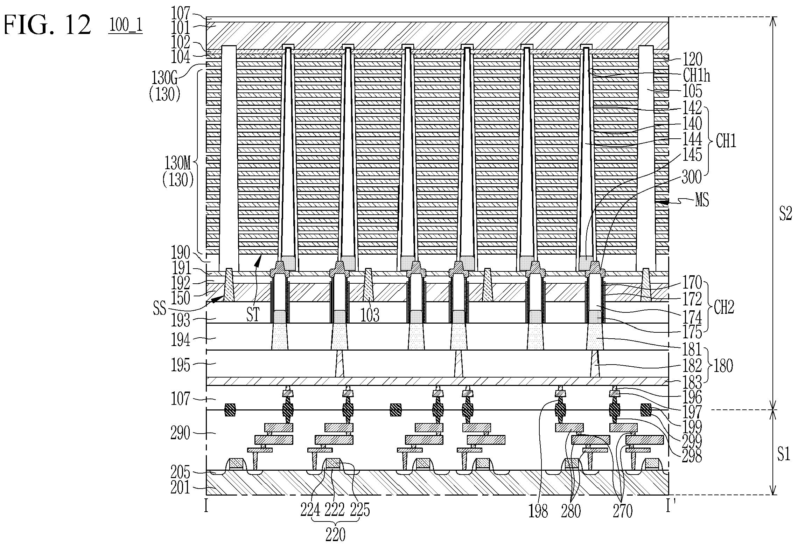

Hereinafter, referring to FIG. 12, another embodiment of the semiconductor device will be described. In the following embodiment, the same reference numerals refer to the same configuration as the previously described embodiment, and redundant descriptions will be omitted or simplified, and the differences will be mainly described.

FIG. 12 is a cross-sectional view of a semiconductor device according to an embodiment. FIG. 12 illustrates a portion of FIG. 1, taken along the line I-I'.

According to an embodiment shown in FIG. 12, a semiconductor device 100_1 may include a first structure S1 and a second structure S2 bonded by wafer bonding.

For the first structure S1, the description of the peripheral circuit region PERI described above with reference to FIG. 3 may be applied substantially the same. However, the first structure S1 may further include first bonding vias 298 and first bonding pads 299 which are bonding structures.

Specifically, the first bonding vias 298 may be disposed above the uppermost circuit wiring lines 280 and connected to the circuit wiring lines 280 . At least a portion of the first bonding pads 299 may be connected to the first bonding vias 298 on the first bonding vias 298 . The first bonding pads 299 may be connected to the second bonding pads 199 of the second structure S2. Together with the second bonding pads 199, the first bonding pads 299 may provide an electrical connection path according to the bonding of the first structure S1 and the second structure S2. The first bonding vias 298 and the first bonding pads 299 may include a conductive material, for example, copper (Cu). However, this is not restrictive.

When there is no separate explanation for the second structure S2, except that the substrate 101 and first channel structure CH1 of the second structure S2 are disposed on the upper side and the second channel structure CH2 is disposed on the lower side, the contents described with reference to FIG. 1 to FIG. 11, may be applied substantially the same.

An upper wire structure of the second structure S2 may further include a conductive via 196 and a conductive line 197 connected to the upper wire 183. In FIG. 12, a plurality of conductive lines 197 are illustrated to be disposed at the same level, but are not limited thereto, and in some embodiments, unlike that shown in FIG. 12, the conductive line 197 may include a plurality of conductive lines disposed at different levels.

In addition, the second structure S2 may further include second bonding vias 198 and second bonding pads 199, which are bonding structures. The second structure S2 may further include a protective layer 107 covering an upper surface of the substrate 101.

The second bonding vias 198 and the second bonding pads 199 may be disposed below the lowermost conductive line 197. The second bonding vias 198 may be connected to the conductive line 197 and the second bonding pads 199, and the second bonding pads 199 may be bonded with the first bonding pads 299 of the first structure S1. The second bonding vias 198 and the second bonding pads 199 may include a conductive material, for example, copper (Cu). However, this is not restrictive.

The first structure S1 and the second structure S2 may be bonded by copper (Cu)-copper (Cu) bonding by first bonding pads 299 and second bonding pads 199. In addition to the copper (Cu)-copper (Cu) bonding, the first structure S1 and the second structure S2 may additionally be bonded by dielectric material-dielectric bonding. The dielectric material-dielectric bonding forms a part of each of the peripheral region insulation layer 290 and the cell region insulation layer 190, and may be bonding by dielectric layers surrounding each of the first bonding pads 299 and the second bonding pads 199. Accordingly, the first structure S1 and the second structure S2 may be bonded without a separate adhesive layer.

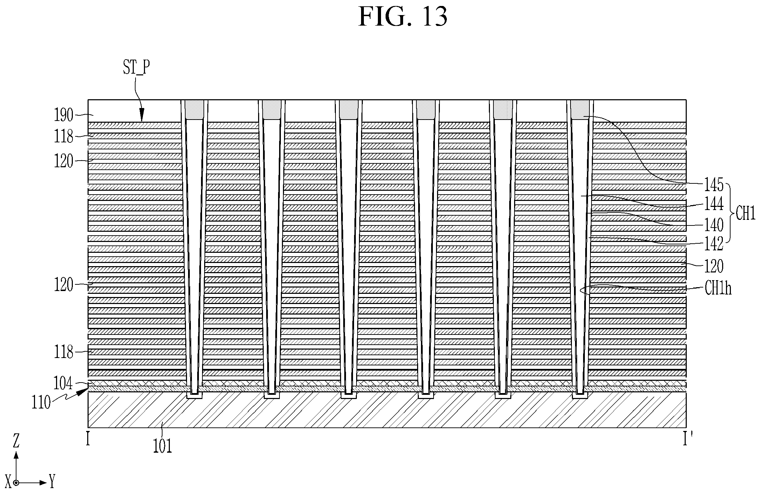

Hereinafter, a manufacturing method of a semiconductor device will be described with reference to FIG. 13 to FIG. 27. Hereinafter, the same configuration described previously is referred to as the same reference symbols, and duplicate descriptions will be omitted or simplified, and the differences will be mainly explained.

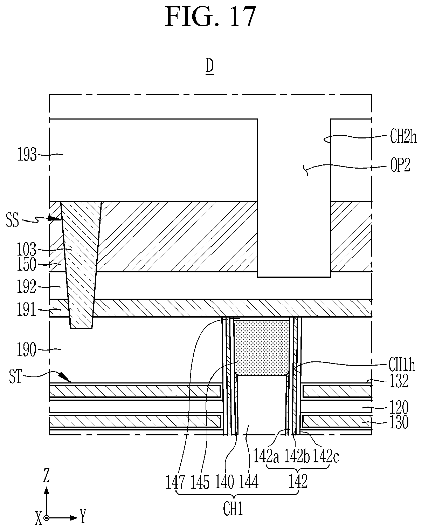

FIG. 13 to FIG. 16 are cross-sectional views of a manufacturing method of a semiconductor device according to embodiments. FIG. 17 to FIG. 27 are partially enlarged views of a manufacturing method of a semiconductor device according to embodiments.

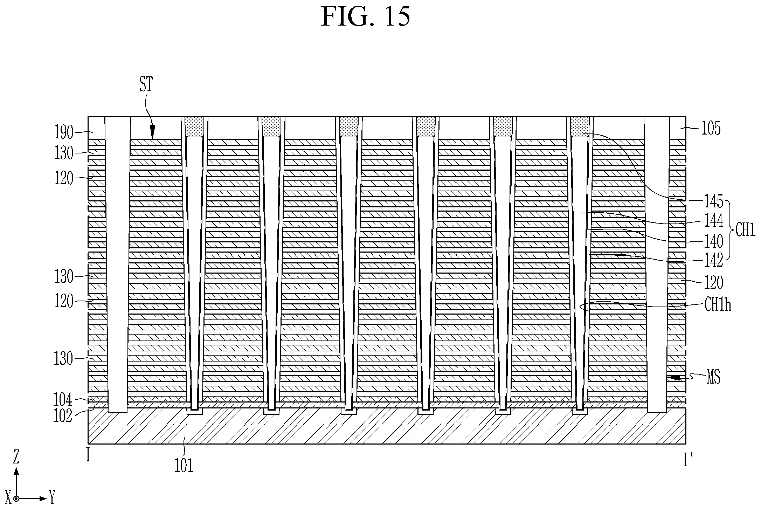

Specifically, in FIG. 13 to FIG. 16, regions corresponding to the regions shown in FIG. 3 are illustrated, and in FIG. 17 to FIG. 27, enlarged regions of the region D of FIG. 15 are illustrated.

Referring to FIG. 13, a horizontal sacrificial layers 110 and a second horizontal conductive layer 104 are formed on a substrate 101, sacrificial insulation layers 118 and interlayer insulation layers 120 are alternately stacked, and then first channel structures CH1 may be formed.

Although it is not illustrated in FIG. 13, the horizontal sacrificial layers 110 may include first to third horizontal sacrificial layers sequentially formed on the substrate 101. The second horizontal sacrificial layer may contain a different material than the first horizontal sacrificial layer and the third horizontal sacrificial layer. The horizontal sacrificial layers 110 may be layers replaced with a first horizontal conductive layer (refer to 102 in FIG. 15) through a subsequent process. For example, the first and third horizontal sacrificial layers may be formed of the same material as the interlayer insulation layers 120, and the second horizontal sacrificial layer may be formed of the same material as the sacrificial insulation layers 118. A second horizontal conductive layer 104 may be formed on the horizontal sacrificial layers 110 .

The sacrificial insulation layers 118 may be a layer of which a part is replaced with a first gate electrodes (refer to 130 in FIG. 15) through a subsequent process. The sacrificial insulation layers 118 may be formed of a material different from that of the interlayer insulation layers 120, and may be formed of a material that can be etched with etching selectivity under a specific etching condition for the interlayer insulation layers 120. For example, the interlayer insulation layer 120 may be formed of at least one of a silicon oxide and a silicon nitride, and the sacrificial insulation layers 118 may be formed of a different material from the interlayer insulation layer 120 selected from silicon, a silicon oxide, a silicon carbide, and a silicon nitride. In some embodiments, the interlayer insulation layers 120 may not all have the same thickness. The thickness and number of layers forming the interlayer insulation layers 120 and the sacrificial insulation layers 118 may be variously changed.

Subsequently, a cell region insulation layer 190 covering a preliminary stacking structure ST_P formed of the sacrificial insulation layers 118 and the interlayer insulation layers 120 may be formed, and openings corresponding to the first channel holes CH1h may be formed. The first channel hole CH1h may be formed in a hole form by anisotropic etching the sacrificial insulation layers 118 and the interlayer insulation layers 120 on the preliminary stacking structure ST_P using a mask layer. Due to a height of the preliminary stacking structure ST_P, sidewalls of the first channel holes CH1h may not be perpendicular to the upper surface of the substrate 101. The first channel holes CH1h may be formed to recess a portion of the substrate 101.

Subsequently, a first dielectric layer 142, a first channel layer 140, a first fill insulation layer 144, and a first channel pad 145 may be sequentially formed in the first channel hole CH1h. The first dielectric layer 142 may be formed to have a uniform thickness using an atomic layer deposition (ALD) process or a chemical vapor deposition (CVD) process.

The first channel layer 140 may be formed on the first dielectric layer 142 within the first channel structure CH1. The first fill insulation layer 144 is formed to fill the inside of the first channel structure CH1 and may be an insulating material. The first channel pad 145 may be formed of a conductive material or, for example, polysilicon. However, this is not restrictive.

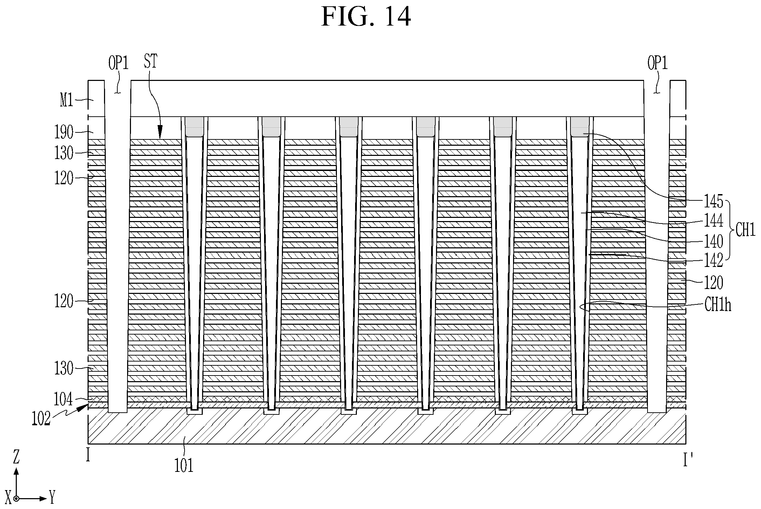

Referring to FIG. 14, first openings OP1 penetrating the stacking structure ST formed of the sacrificial insulation layers 118 and the interlayer insulation layers 120 are formed in regions corresponding to the separation regions (refer to MS in FIG. 15), and a first horizontal conductive layer 102 and a first gate electrodes 130 may be formed.

First, a mask layer M1 is formed on the first channel structure CH1, and then a first opening OPIs may be formed. The first openings OP1 may be formed to penetrate the preliminary stacking structure ST_P formed of the sacrificial insulation layers 118 and the interlayer insulation layers 120, penetrate the second horizontal conductive layer 104 at the bottom, and extend in the third direction (Z direction).

Next, the second horizontal sacrificial layer may be exposed by an etch back process while forming separate sacrificial spacer layers within the first openings OP1. The exposed second horizontal sacrificial layer is selectively removed, and then the first and third horizontal sacrificial layers above and below may be removed.

The horizontal sacrificial layers 110 may be removed by, for example, a wet etching process. During the process of removing the horizontal sacrificial layers 110, a portion of the first dielectric layer 142 exposed in the region from which the horizontal sacrificial layers 110 are removed may also be removed. After forming the first horizontal conductive layer 102 by depositing a conductive material in the region from which the horizontal sacrificial layers 110 are removed, the sacrificial spacer layers may be removed in the first openings OP1.

Next, tunnel portions may be formed by removing the sacrificial insulation layer 118 exposed by the first openings OP1, and the first gate electrodes 130 may be formed by filling the tunnel portions with a conductive material. The tunnel portions may be formed, for example, through a wet etching process that selectively removes the sacrificial insulation layers 118 with respect to the interlayer insulation layers 120.

The conductive material forming the first gate electrodes 130 may include a metal, polysilicon, or a metal silicide material. In the present stage, a gate dielectric layer (refer to 132 in FIG. 4) may be formed by depositing a dielectric layer having a conformal thickness before forming the first gate electrodes 130. Next, the first openings OP1 may be formed again by removing the conductive material.

In some embodiments, upon removal of the conductive material, the first gate electrodes 130 may be partially removed from the first openings OP1. The first gate electrodes 130 may include regions that are partially recessed from the first openings OP1 compared to the interlayer insulation layers 120 .

Referring to FIG. 15, it is possible to form a separation insulation layer 105 in the separation regions MS.

After filling the first openings OP1 with an insulating material, a planarization process is performed to remove the mask layer M1 and the insulating material, and the separation insulation layer 105 may be formed. The insulating material may include a silicon oxide, a silicon nitride, or a silicon oxynitride. However, it is not limited thereto, and in some embodiments, the first openings OP1 may be filled with a conductive material together with the insulating material.

The planarization process may be performed such that the upper surfaces of the separation insulation layer 105 in the separation regions MS are disposed at substantially the same level as the upper surfaces of the first channel structures CH1.

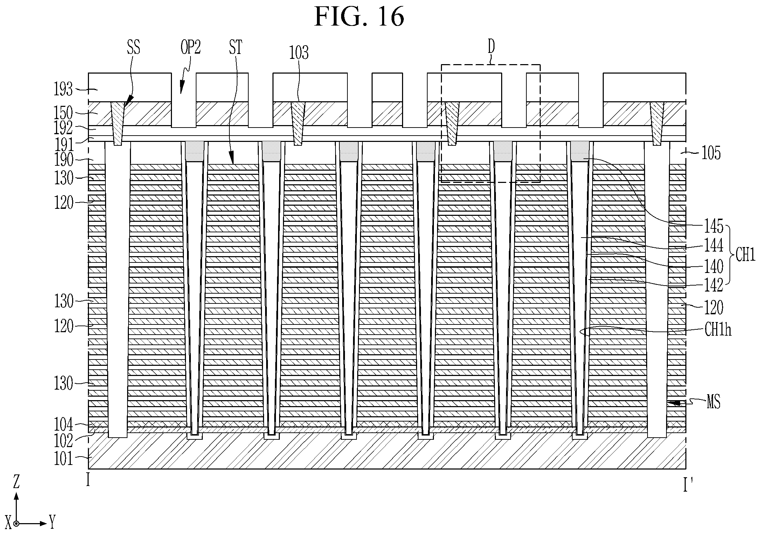

Subsequently, referring to FIG. 16 and FIG. 17, an insulation pattern 191, an upper separation insulation layer 103 in upper separation regions SS, and a second selection gate electrode 150 may be formed.

An insulation pattern 191, a first upper insulation layer 192, and a second selection gate electrode 150 are sequentially formed on the separation regions MS and the cell region insulation layer 190 by a deposit process, and then the upper separation insulation layer 103 may be formed the upper separation regions SS and the second upper insulation layer 193 may be formed through a deposit process.

Here, the insulation pattern 191 may be extended in the first direction (X direction) and the second direction (Y direction). The insulation pattern may have an integral structure in which portions other than the plurality of penetration portions are connected. In addition, the insulation pattern 191 may include a material different from that of the cell region insulation layer 190 and/or first upper insulation layer 192. For example, the insulation pattern 191 may be formed of a material that can be etched with etching selectivity under a specific etching condition with respect to the cell region insulation layer 190 and the first upper insulation layer 192.

The second selection gate electrode 150 may be formed by depositing a conductive material, for example, doped polysilicon. The second selection gate electrode 150 may be formed to have a larger thickness than each of the first gate electrodes 130. However, this is not restrictive.

Trenches that penetrate the second selection gate electrode 150 and the insulation pattern 191 to expose the first upper insulation layer 192 are formed to form regions corresponding to the upper separation regions SS, an insulating material is deposited in the trenches, and planarization is carried out to form the upper separation insulation layer 103.

Next, a patterning process is carried out using the second upper insulation layer 193 as a mask such that second opening OP2s that penetrate the second upper insulation layer 193 and correspond to the second channel holes CH2h can be formed. The second openings OP2 may expose the first upper insulation layer 192. The second openings OP2 may be formed of a plurality of holes in a circular shape, and may include a portion that does not overlap and a portion that overlaps the first channel structures CH1 on a plane.

A portion of the first upper insulation layer 192 is removed by the patterning process, and the first upper insulation layer 192 may include a portion recessed by the second opening OP2, but this is not restrictive, and in some embodiments, the first upper insulation layer 192 may not be removed and an upper surface of the first upper insulation layer 192 may be exposed.

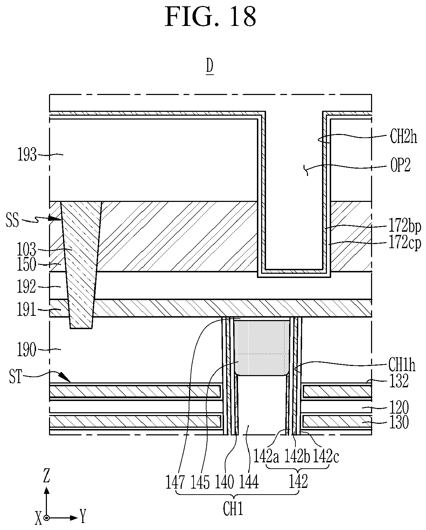

Then, referring to FIG. 18, a second preliminary blocking layer 172cp and a second preliminary charge storage layer 172bp may be sequentially formed in the second opening OP2.

Specifically, a deposit process may be sequentially performed to form the second preliminary blocking layer 172cp, and the second preliminary charge storage layer 172bp conformally covering the second upper insulation layer 193, the sidewall and the bottom surface of the second opening OP2.

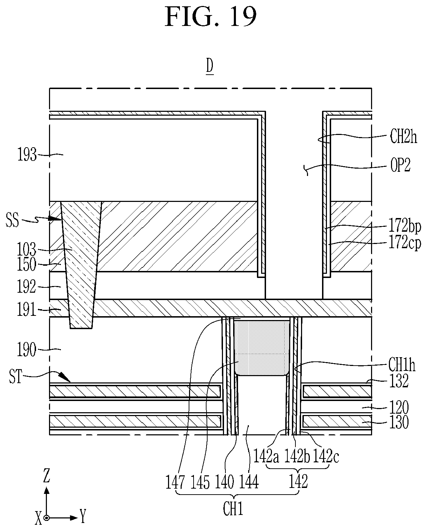

Then, referring to FIG. 19, a hole extending below the bottom surface of the second opening OP2 may be formed. The hole may expose the insulation pattern 191 by performing an etch back process on the second opening OP2.

As the etch back process is performed, the first upper insulation layer 192 disposed below the bottom surface of the second opening OP2 is removed together with the second preliminary blocking layer 172cp and the second preliminary charge storage layer 172bp sequentially disposed on the bottom surface of the second opening OP2 such that the insulation pattern 191 can be exposed. That is, the upper surface of the insulation pattern 191 may be exposed through the etch back process.

As described above, as the insulation pattern 191 is formed of a material having etching selectivity with respect to the first upper insulation layer 192, during the etch back process, a portion of the first upper insulation layer 192 is removed to expose the upper surface of the insulation pattern 191.

However, it is not limited thereto, and as the etch back process is performed, a part of the insulation pattern 191 may also be removed. That is, the insulation pattern 191 may include a region partially recessed from the hole.

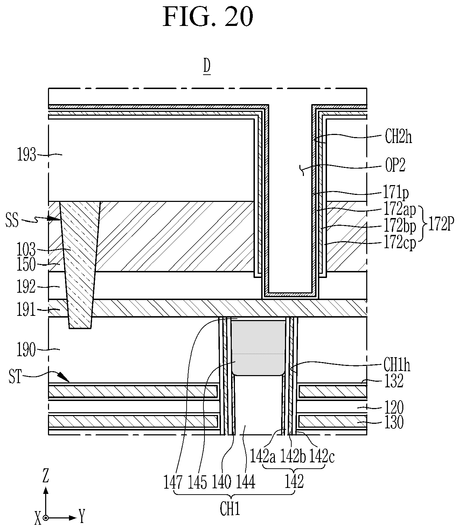

Then, referring to FIG. 20, a second preliminary tunnelling layer 172ap and a preliminary semiconductor spacer layer 171p may be sequentially formed in the second opening OP2.

Specifically, a deposit process is sequentially performed to form a second preliminary tunnelling layer 172ap and the preliminary semiconductor spacer layer 171p conformally covering the second preliminary charge storage layer 172bp, the side surface of the first upper insulation layer 192 and the upper surface of the insulation pattern 191. The preliminary semiconductor spacer layer 171p may include amorphous silicon.

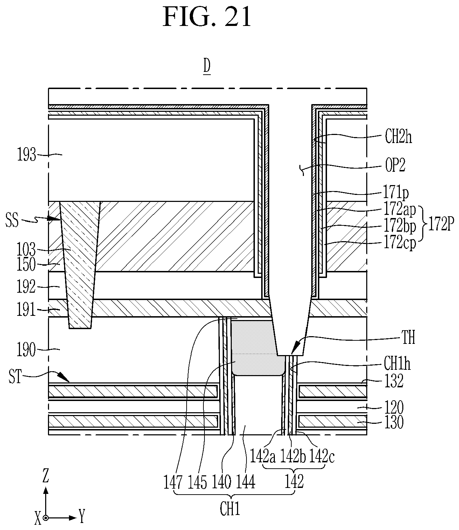

Then referring to FIG. 21, a through-hole TH extending below the bottom of the second opening OP2 may be formed. The through-hole TH may perform an etching process on the second opening OP2 such that the first channel pad 145 and the first dielectric layer 142 may be exposed. As the through-hole TH is formed, a recess may be provided in the first channel pad 145 and the first dielectric layer 142 .

The etching process may be dry etching, but is not limited thereto. As the etching process is performed, the insulation pattern 191 may be removed together with the preliminary semiconductor spacer layer 171p and the second preliminary tunnelling layer 172ap sequentially disposed on the bottom surface of the second opening OP2. In addition, as the etching process is performed, portions of the capping pad 147, the first channel pad 145, and the first dielectric layer 142 may be removed together. That is, the first channel structure CH1 may include a portion partially recessed from the through-hole TH. Accordingly, the first channel pad 145 and the first dielectric layer 142 may be exposed through the etching process. As the through-hole TH recessing a part of the first channel pad 145 and a part of the first dielectric layer 142 is formed, an area in which the first channel pad 145 and the first dielectric layer 142 are exposed may increase compared to the case that the through-hole TH does not recess the first channel pad 145 and the first dielectric layer 142.

In an embodiment, the through-hole TH penetrates the insulation pattern 191 to form a recess in the first channel pad 145 and first dielectric layer 142. That is, the etching of the through-hole TH is stopped at the first channel pad 145 and the first dielectric layer 142 having a relatively thicker thickness than the insulation pattern 191. Accordingly, the through-hole TH may stably penetrate the insulation pattern 191. On the other hand, in the prior art, when a through-hole is formed by an etching process, the through-hole penetrates the insulation pattern and stops etching at the insulation pattern. However, there were cases where it was difficult to stop etching at the insulation pattern because a critical dimension (CD) of the through-hole was small, and thus it could not penetrate the insulation pattern. As in the embodiment, when the second channel structure is smaller than the first channel structure, this problem may occur more severely.

In some embodiments, as the etching process is performed, a portion of the cell region insulation layer 190 may also be removed. For example, when a part of the second opening OP2 overlaps the first channel structure CH1 in the third direction (Z direction), a part of the cell region insulation layer 190 may be removed as the etch back process is performed. However, this is not restrictive, and when the second opening OP2 completely overlaps the first channel structure CH1 in the third direction (Z direction), the cell region insulation layer 190 may be not removed.

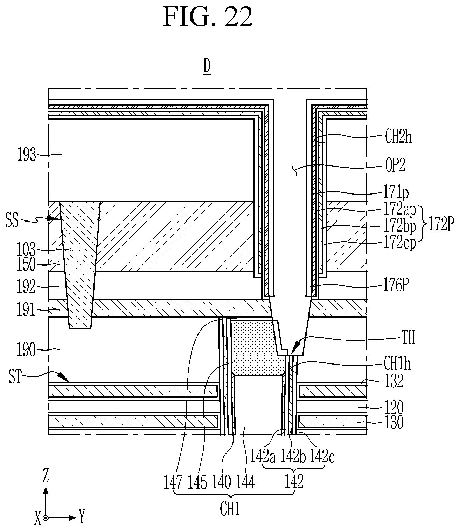

Then, referring to FIG. 22, a preliminary insulation layer 176P may be partially formed in the second opening OP2 and the through-hole TH.

Specifically, the preliminary insulation layer 176P may be formed to conformally cover the preliminary semiconductor spacer layer 171p and the first channel pad 145 exposed in the through-hole TH. The preliminary insulation layer 176P may be formed using a chemical oxidation method, an ultraviolet rays oxidation (UV oxidation) method, or a dual plasma oxidation method. The preliminary insulation layer 176P may include a silicon oxide, but is not limited thereto.

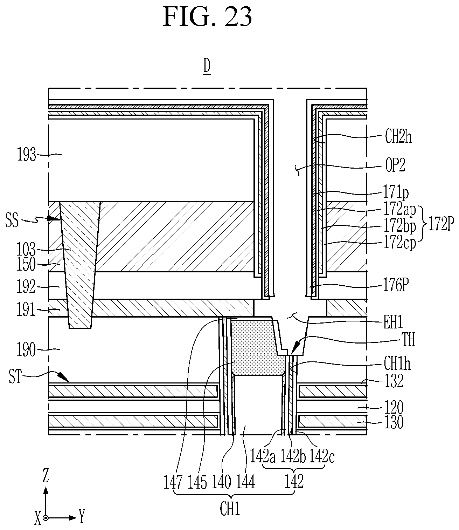

Then, referring to FIG. 23, a first expansion hole EH1 may be formed in the insulation pattern 191. The process of forming the first expansion hole EH1 may include performing an etching process on the insulation pattern 191 exposed by the through-hole TH.

The etching process may be performed using a wet etching liquid that can selectively etch the insulation pattern 191 among the insulation pattern 191 and the preliminary insulation layer 176P. In addition, the wet etching liquid may have high etch selectivity for the insulation pattern 191 among the capping pad 147, the cell region insulation layer 190, and the insulation pattern 191.

Accordingly, the insulation pattern 191 may be etched along the second direction (Y direction), which is a horizontal direction. That is, as the insulation pattern 191 is etched along the second direction (Y direction), the first expansion hole EH1 may expose the top surface of the capping pad 147, the top surface of the cell region insulation layer 190, and the side surface of the insulation pattern 191. In this case, when the first charge storage layer 142b of the first dielectric layer 142 includes the same material as the insulation pattern 191, the first charge storage layer 142b may also be etched while the insulation pattern 191 is etched, but this is not restrictive.

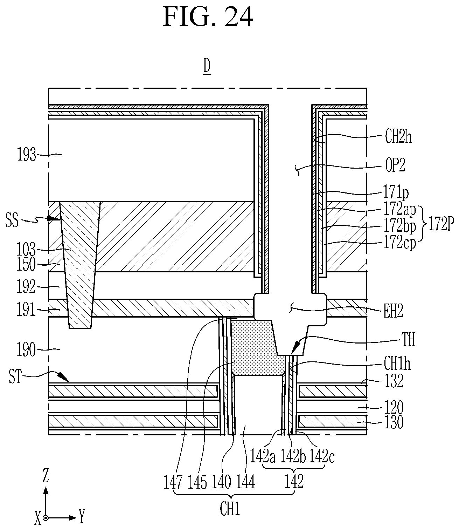

Then, referring to FIG. 24, the preliminary insulation layer 176P may be removed, and a second expansion hole EH2 extending above the top surface and below the bottom surface of the first expansion hole EH1 may be formed. The second expansion hole EH2 may include performing an etching process on the first upper insulation layer 192, the cell region insulation layer 190, and the capping pad 147 exposed by the first expansion hole EH1.

The etching process may be performed using a wet etching solution that can selectively etch the preliminary insulation layer 176P among the preliminary semiconductor spacer layer 171p, the preliminary insulation layer 176P, and the first channel pad 145. Accordingly, the preliminary insulation layer 176P disposed on the preliminary semiconductor spacer layer 171p and the first channel pad 145 may be removed. In addition, the wet etching liquid may have high etch selectivity with respect to the preliminary insulation layer 176P of the preliminary insulation layer 176P and the insulation pattern 191.

In the process of removing the preliminary insulation layer 176P, parts of the capping pad 147, the cell region insulation layer 190, and the first upper insulation layer 192 may be removed together. Specifically, the exposed capping pad 147 and first upper insulation layer 192 may be etched along the third direction (Z direction), which is a vertical direction. In addition, the exposed cell region insulation layer 190 may be etched along the second direction (Y direction), which is a horizontal direction. Accordingly, a portion of the cell region insulation layer 190 and a portion of the capping pad 147 may be removed along the third direction (Z direction). In this case, a thickness of one side of the second extension hole EH2 along the third direction (Z direction) may be greater than a thickness of the other side of the second extension hole EH2 along the third direction (Z direction).

Accordingly, as the second expansion hole EH2 is formed, the first dielectric layer 142 and the first channel pad 145 may be exposed. For example, a portion where the second expansion hole EH2 is positioned on the first dielectric layer 142 and a portion where the second expansion hole EH2 is positioned on the first channel pad 145 may be positioned on the same plane. Accordingly, the portions may be positioned on the same plane through a process of simultaneously etching the first dielectric layer 142 and the first channel pad 145. Therefore, in the process of forming the second expansion hole EH2 of the semiconductor device 100 according to an embodiment, the first dielectric layer 142 is etched to prevent the second portion 320 from extending in the third direction (Z direction) along the sidewall of the first channel layer 140.

In addition, as the second expansion hole EH2 is formed, the upper surface of the first channel pad 145 may be partially exposed. That is, as the upper surface of the first channel pad 145 is further exposed, an area in which the first channel pad 145 is exposed may increase.

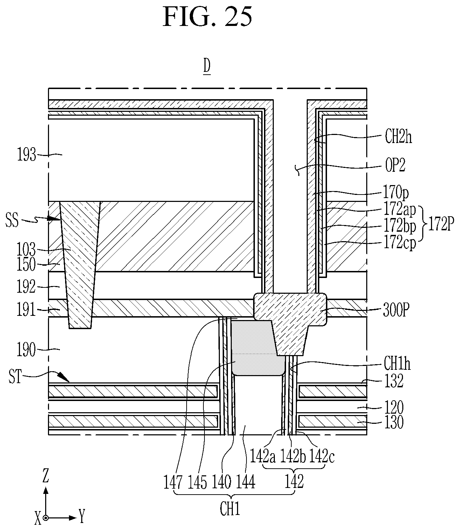

Then, referring to FIG. 25, a preliminary contact pattern 300P may be formed in the second opening OP2 and the second expansion hole EH2.

First, the preliminary semiconductor spacer layer 171p may be removed through an etching process. As the etching process is performed, the second preliminary tunnelling layer 172ap may be exposed. The etching process may be performed using an etching solution that can selectively etch the preliminary semiconductor spacer layer 171p among the preliminary semiconductor spacer layer 171p and the second preliminary tunnelling layer 172ap. In addition, the etching process may be carried out by using etching liquid that can selectively etch the preliminary semiconductor spacer layer 171p among the preliminary semiconductor spacer layer 171p, the first channel pad 145, the first dielectric layer 142, the first upper insulation layer 192, the cell region insulation layer 190, and the insulation pattern 191.

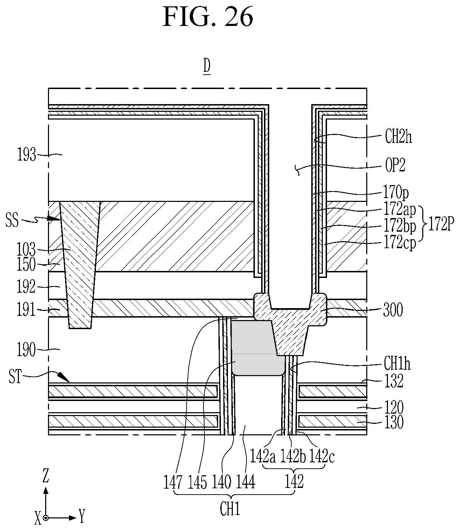

Next, the second expansion hole EH2 is filled with a conductive material to form a contact pattern 300 in contact with the first channel pad 145, and the conductive material is deposited on the upper surface of the second upper insulation layer 193 and in the second opening OP2 to form a second preliminary channel layer 170P, thereby integrally forming the contact pattern 300 and the second channel layer (refer to 170 in FIG. 26). The conductive material may include at least one of a semiconductor material such as polysilicon, a metal material, or a metal silicide.

Specifically, the preliminary contact pattern 300P is formed in the second expansion hole EH2, and the second preliminary channel layer 170P deposited in the second opening OP2 is conformally formed along the inner sidewall of the second opening OP2. The second expansion hole EN2 may be filled without an air gap by the preliminary contact pattern 300P.

Accordingly, the preliminary contact pattern 300P may be connected to the second preliminary channel layer 170P deposited in the second opening OP2. A portion of the upper surface of the first channel pad 145 exposed by the second expansion hole EH2, the first channel pad 145 exposed by the through-hole TH, and the first dielectric layer 142 may be connected to the preliminary contact pattern 300P. In this case, a contact area between the preliminary contact pattern 300P and the first channel pad 145 and between the preliminary contact pattern 300P and the first dielectric layer 142 may increase compared to the case where the through-hole TH or the second expansion hole EH2 is not formed. That is, the preliminary contact pattern 300P and the first channel structure CH1 can be stably connected.

In an embodiment, the contact pattern 300 and the second channel layer 170 may be integrally formed as formed by the same deposit process, but this is not restrictive, and in some embodiments, the contact pattern 300 and the second channel layer 170 may be formed through a plurality of deposit processes using different conductive materials.

Then, referring to FIG. 26, a thickness of the second preliminary channel layer 170P can be reduced by etching at least a part of the second preliminary channel layer 170P. As at least a part of the second preliminary channel layer 170P is etched, at least a part of the preliminary contact pattern 300P may be removed. Accordingly, the contact pattern 300 may be formed.

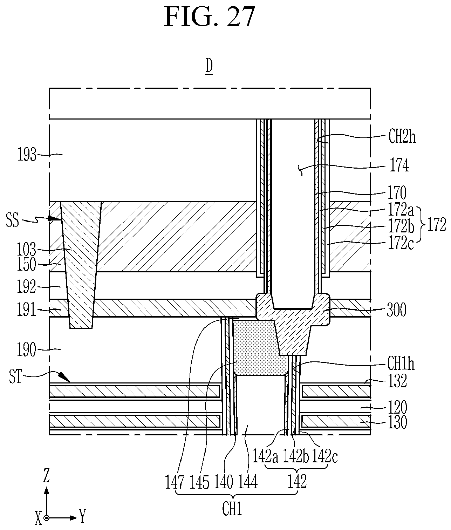

Subsequently, further referring to FIG. 27, a second fill insulation layer 174 may be formed within the second opening OP2.

Specifically, the second fill insulation layer 174 may be formed by filling an insulating material in the second opening OP2 and then performing a planarization process. In the planarization process, the second preliminary blocking layer 172cp, the second preliminary charge storage layer 172bp, and the second preliminary channel layer 170P sequentially stacked on the upper surface of the second upper insulation layer 193 may be removed together with the insulating material.

Accordingly, as the planarization process is performed on each of the second preliminary blocking layer 172cp, the second preliminary charge storage layer 172bp, the second preliminary tunnelling layer 172ap, and the second preliminary channel layer 170P such that the second blocking layer 172c, the second charge storage layer 172b, the second tunnelling layer 172a, and the second channel layer 170 can be formed.

Subsequently, further referring to FIG. 3, after forming an opening to remove a part of the second fill insulation layer 174, a second channel pad 175 is formed, and then a stud 181 contacting the channel pad 175 while passing through the third upper insulation layer 194 and third upper insulation layer 194 covering the second channel pad 175 may be formed.

Then, the semiconductor device 100 shown in FIG. 3 can be formed by forming a fourth upper insulation layer 195 covering the third upper insulation layer 194, a contact plug 182 that contacts the stud 181 by penetrating the fourth upper insulation layer 195, and an upper wire 183 on the contact plug 182.

Hereinafter, referring to FIG. 28 to FIG. 31, an electronic system including the above-described semiconductor device will be exemplarily described in detail.

FIG. 28 schematically shows an electronic system including the semiconductor devices according to some embodiments.

Referring to FIG. 28, a semiconductor system 1000 according to some embodiments may include a semiconductor device 1100 and a controller electrically connected to the semiconductor device 1100. The electronic system 1000 may be a storage device including one or a plurality of semiconductor devices 1100 or an electronic device including storage devices. For example, the electronic system 1000 may be a solid state drive device (SSD) including one or a plurality of semiconductor devices 1100, a universal serial bus (USB), a computing system, a medical device, or a communication device.

The semiconductor device 1100 may be a non-volatile memory device, and, for example, may be the NAND flash memory device described with reference to FIG. 1 to FIG. 27. The semiconductor device 1100 may include a first structure 1100F and a second structure 1100S on the first structure 1100F. In some embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CSL, a word line WL, first and second gate upper lines LTL1 and UL2, first and second gate lower lines LL1 and LL2, and memory cell string CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be variously modified according to embodiments.

In some embodiments, the lower transistors LT1 and LT2 may include ground select transistors, and upper transistors UT1 and UT2 may include string select transistors. First and second gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2, respectively.

The common source line CSL, the first and second gate lower lines LL1 and LL2, the word line WL, and the first and second gate upper lines LTL1 and UL2 may be electrically connected with a decoder circuit 1100 through the first connection wiring 1115 extending to the second structure 1100S in the first structure 1100F. The bit line BL may be electrically connected to a page buffer 1120 through the second connection wiring 1125 extending to the second structure 1100S in the first structure 1100F.

In the first structure 1100F, the decoder circuit 1110 and the page buffer 1120 may execute a control operation on at least one memory cell transistor selected from the plurality of memory cell transistors MCT. The decoder circuit 1110 and the page buffer 1120 may be controlled by a logic circuit 1130. The semiconductor device 1100 may communicate with the controller 1200 through an input and output pad 1101 electrically connected to the logic circuit 1130. The input and output pad 1101 may be electrically connected to the logic circuit 1130 through an input and output connection wiring 1135 extending to the second structure 1100S in the first structure 1100F.

The controller 1200 may include a processor 1210, a NAND controller 1220, and a host interface 1230. Depending on embodiments, the electronic system 1000 may include a plurality of semiconductor devices 1100, and in this case, the controller 1200 may control the plurality of semiconductor devices 1100.

The processor 1210 may control the overall operation of the electronic system 1000 including the controller 1200. The processor 1210 may operate according to predetermined firmware, and may access the semiconductor device 1100 by controlling the NAND controller 1220. The NAND controller 1220 may include a NAND interface 1221 that handles communication with the semiconductor device 1100. Control instructions for controlling the semiconductor device 1100, data to be written to the memory cell transistor (MCT) of the semiconductor device 1100, data to be read from the memory cell transistor (MCT) of the semiconductor device 1100, and the like can be transmitted through the NAND interface 1221. The host interface 1230 may provide a communication function between the electronic system 1000 and an external host. When a control instruction is received from an external host through the host interface 1230, the processor 1210 may control the semiconductor device 1100 in response to the control instruction.

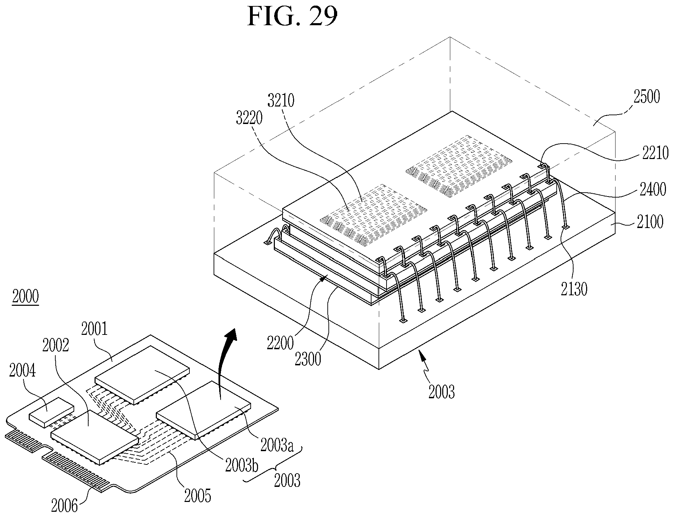

FIG. 29 is a schematic perspective view of an electronic system including a semiconductor device according to some embodiments.

Referring to FIG. 29, an electronic system 2000 according to some embodiment may include a main substrate 2001, a controller 2002 mounted on the main substrate 2001, one or more semiconductor package 2003, and a DRAM 2004. The semiconductor package 2003 and the DRAM 2004 may be connected to the controller 2002 by a wiring pattern 2005 formed on the main substrate 2001.

The main substrate 2001 may include a connector 2006 including a plurality of pins coupled to an external host. The number and placement of the plurality of pins in the connector 2006 may vary depending on a communication interface between the electronic system 2000 and the external host. In some embodiments, the electronic system 2000 may communicate with external hosts through any one of interfaces such as a universal serial bus (USB), a peripheral component interconnect express (PCI-Express), a serial advanced technology attachment (SATA), M-Phy for universal flash storage (UFS), and the like. In some embodiments, the electronic system 2000 may operate by power supplied from an external host through the connector 2006. The electronic system 2000 may further include a power management integrated circuit (PMIC) that distributes power supplied from the external host to the controller 2002 and the semiconductor package 2003.

The controller 2002 may write data to the semiconductor package 2003 or read data from the semiconductor package 2003, and may improve the operation speed of the electronic system 2000.

The DRAM 2004 may be a buffer memory for mitigating a speed difference between the semiconductor package 2003, which is a data storage space, and an external host. The DRAM 2004 included in the electronic system 2000 may also operate as a kind of cache memory, and may provide a space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. The first and second semiconductor packages 2003a and 2003b may be semiconductor packages each including a plurality of semiconductor chips 2200. Each of the first and second semiconductor packages 2003a and 2003b includes a package substrate 2100, a semiconductor chip 2200 on the package substrate 2100, an adhesive layer 2300 disposed on a bottom surface of each semiconductor chip 2200, a connection structure 2400 electrically connecting the semiconductor chip 2200 and the substrate package 2100, and a molding layer 2500 covering the semiconductor chip 2200 and the connection structure 2400 on the package substrate 2100.

The package substrate 2100 may be a printed circuit board including a package upper pad 2130. Each semiconductor chip 2200 may include an input and output pad 2210. The input and output pad 2210 may correspond to the input and output pad 1101 of FIG. 28. Each semiconductor chip 2200 may include a gate stacking structure 3210 and a channel structure 3220. Each semiconductor chip 2200 may include the semiconductor device described with reference to FIG. 1 to FIG. 27.

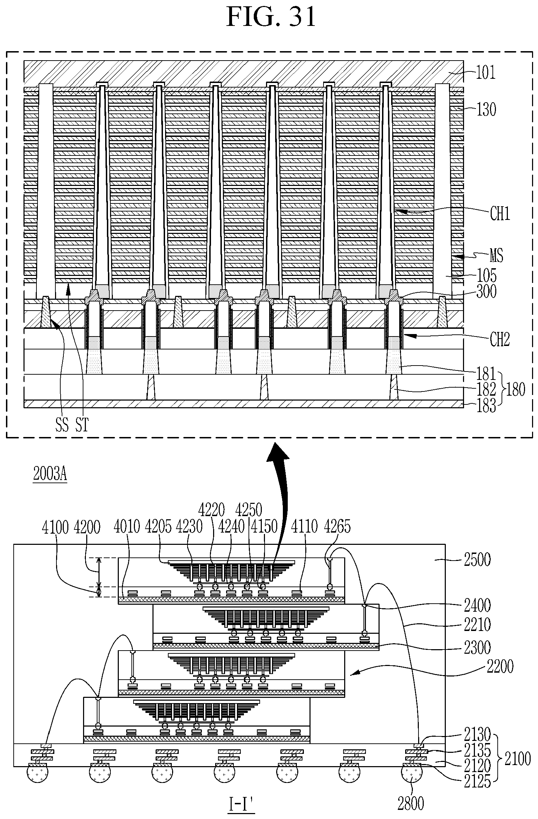

FIG. 30 and FIG. 31 schematic cross-sectional views of semiconductor packages according to some embodiments.

Referring to FIG. 30, in a semiconductor package 2003, a package substrate 2100 may be a printed circuit board. The package substrate 2100 may include a package substrate body 2120, a package upper pad 2130 disposed on an upper surface of the package substrate body 2120, a lower pad 2125 disposed on or exposed through a lower surface of the package substrate body 2120, and an internal wiring 2135 electrically connecting the upper pad 2130 and the lower pad 2125 inside the package body substrate 2120. The upper pad 2130 may be electrically connected to a connection structure 2400. The lower pad 2125 may be connected to a wiring pattern 2005 of a main substrate 2010 of an electronic system 2000 as shown in FIG. 29.

The semiconductor chip 2200 may include a first structure 3100 and a second structure 3200 sequentially stacked on the semiconductor substrate 3010 and the semiconductor substrate 3010, respectively. The first structure 3100 may include a peripheral circuit region including a peripheral wire 3110. The second structure 3200 may include a common source line 3205, a gate stacking structure 3210 on the common source line 3205, a channel structure 3220 and a separation structure 3230 passing through the gate stacking structure 3210, a bit line 3240 electrically connected to the channel structure 3220, and a gate connection wire that is electrically connected with the word line (refer to WL of FIG. 28) of the gate stacking structure 3210.

In the semiconductor chip 2200 or semiconductor device according to the embodiment, since a contact area between a contact pattern 300 and a first channel pad 145 increases, a first channel structure CH1 and a second channel structure CH2 can be stably connected.

Each of the semiconductor chips 2200 may include a through wire 3245 electrically connected to a surrounding wire 3110 of the first structure 3100 and extending into the second structure 3200. The through wire 3245 may pass through the gate stacking structure 3210 and may be further disposed outside the gate stacking structure 3210. Each of the semiconductor chips 2200 may further include an input and output connection wire 3265 and an input and output pad 2210 electrically connected to the input and output connection wire 3265 electrically connected to the surrounding wire 3110 of the first structure 3100 and extending into the second structure 3200.

In some embodiments, a plurality of semiconductor chips 2200 in a semiconductor package 2003 may be electrically connected to each other by a connection structure 2400 in the form of a bonding wire. As another example, the plurality of semiconductor chips 2200 or a plurality of portions forming the same may be electrically connected by a connection structure including a through electrode (through silicon via, TSV).

Referring to FIG. 31, in a semiconductor package 2003A, each semiconductor chip 2200a may include a semiconductor substrate 4010, a first structure 4100 on the semiconductor substrate 4010, and a second structure 4200 bonded with the first structure 4100 on the first structure 4100 by wafer bonding.

The first structure 4100 may include a peripheral circuit region including a peripheral wire 4110 and a first junction structure 4150. The second structure 4200 may include a common source line 4205, a gate stacking structure 4210 between the common source line 4205 and a first structure 4100, a channel structure 4220 and a separation structure 4230 passing through the gate stacking structure 4210, and a second junction structures 4250 electrically connected to a word line of 4210 (refer to WL in FIG. 28, hereinafter the same) of each of the channel structure 4220 and the gate stacking structure 4210. For example, the second junction structure 4250 may be electrically connected to the channel structure 4220 and the word line WL through a gate connection wire electrically connected to a bit line 4240 and the word line WL electrically connected to the channel structure 4220. The first junction structure 4150 of the first structure 4100 and the second junction structure 4250 of the second structure 4200 may be bonded while contacting each other. Bonded portions of the first junction structure 4150 and the second junction structure 4250 may be formed of, for example, copper (Cu).

In a semiconductor chip 2200a or a semiconductor device according to the embodiment, since a contact area between a contact pattern 300 and a first channel pad 145 increases, a first channel structure CH1 and a second channel structure CH2 can be stably connected.

Each semiconductor chip 2200a may further include an input and output pad 2210 and an input and output connection wire 4265 under the input and output pad 2210. The input and output connection wire 4265 may be electrically connected to a part of the second junction structure 4250.

In an embodiment, the plurality of semiconductor chips 2200 in the semiconductor package 2003 may be electrically connected to each other by a connection structure 2400 in the form of a bonding wire. As another example, the plurality of semiconductor chips 2200 or a plurality of portions forming the plurality of semiconductor chips 2200 may be electrically connected by a connection structure including a through electrode.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

### <Description of symbols>

100: semiconductor device
130: first gate electrode
CH1: first channel structure
140: first channel layer
142: first dielectric layer
145: first channel pad
150: second selection gate electrode
CH2: second channel structure
170: second channel layer
172: second dielectric layer
300: contact pattern
310: first portion
320: second portion
190: cell region insulation layer
191: insulation pattern

## Claims

1. A semiconductor device comprising:
a substrate;
a stacking structure that includes a first selection gate electrode and a plurality of memory gate electrodes separately stacked on the substrate;
a first channel structure that penetrates the stacking structure and extends along one direction, and that includes, a first channel layer, a first dielectric layer disposed between the first channel layer and the stacking structure, and a channel pad disposed on the first channel layer;
an insulation pattern that is disposed above the stacking structure and has a penetration portion exposing at least a portion of the first channel structure;
a second selection gate electrode that is disposed on the insulation pattern; and
a second channel structure that extends in the one direction to penetrate the second selection gate electrode, and that includes a contact pattern connected to the first channel structure,
wherein the contact pattern includes:
a first portion including a portion disposed within the penetration portion on an upper surface of the channel pad, and
a second portion that protrudes toward the substrate to include a recess in the channel pad and the first dielectric layer, the second portion protruding from inside a bottom surface of the first portion.

2. The semiconductor device as claimed in claim 1, wherein the first portion has an extension extending outward from an edge of the second portion at the top of the second portion.

3. The semiconductor device as claimed in claim 2, wherein a thickness of the extension is greater than a thickness of the insulation pattern.

4. The semiconductor device as claimed in claim 1, 2, or 3 wherein an upper surface of the first portion is disposed closer to the second selection gate electrode than an upper surface of the insulation pattern.

5. The semiconductor device as claimed in any one of claims 1 to 4, wherein a bottom surface of the second portion is disposed on the same plane with a portion disposed on the first dielectric layer and a portion disposed on the channel pad.

6. The semiconductor device as claimed in any one of claims 1 to 5, wherein:
the first channel structure includes a plurality of first channel structures,
the penetration portion includes a plurality of penetration portions respectively corresponding to the plurality of first channel structures, and
the insulation pattern has an integral structure in which parts other than the plurality of penetration portions are connected.

7. The semiconductor device as claimed in claim 6, further including an upper separation region penetrating the insulation pattern.

8. The semiconductor device as claimed in any one of claims 1 to 7, further including a cell region insulation layer that is disposed between the insulation pattern and the stacking structure and covers an upper surface of the stacking structure and a side surface of the first channel structure,
wherein, on a plane, one side of the first portion overlaps the cell region insulation layer and the other side of the first portion overlaps the first channel structure.

9. The semiconductor device as claimed in claim 8, wherein a portion of the second portion of the channel pad overlaps the cell region insulation layer in the one direction.

10. The semiconductor device as claimed in claim 8 or 9, wherein a thickness of the one side of the first portion is greater than a thickness of the other side of the first portion.

11. The semiconductor device as claimed in claim 10, wherein a bottom surface of the one side of the first portion is disposed closer to the stacking structure than a bottom surface of the other side of the first portion.

12. The semiconductor device as claimed in any one of claims 1 to 11, wherein a thickness of the second portion of the contact pattern is greater than a thickness of the first portion of the contact pattern.

13. The semiconductor device as claimed in any one of claims 1 to 12, wherein a width of the second channel structure is less than a width of the first channel structure.

14. The semiconductor device as claimed in claim 13, wherein at least a part of the first channel structure overlaps with the second channel structure in one direction.

15. The semiconductor device as claimed in any one of claims 1 to 14, wherein:
a thickness of the second selection gate electrode along the one direction is greater than a thickness of the first selection gate electrode along the one direction, and
the second selection gate electrode contains a material different from the first selection gate electrode.
